(19) Europäisches Patentamt
European Patent Office
Office européen des brevets

(11) EP 4 614 550 A1

(12) **EUROPEAN PATENT APPLICATION**
published in accordance with Art. 153(4) EPC

(43) Date of publication:
**10.09.2025 Bulletin 2025/37**

(21) Application number: **23885531.6**

(22) Date of filing: **18.10.2023**

(51) International Patent Classification (IPC):
***H01L 21/302** (2006.01)* ***C23F 1/12** (2006.01)*
***H01L 21/3065** (2006.01)*

(52) Cooperative Patent Classification (CPC):
**C23F 1/12; H01L 21/302; H01L 21/3065**

(86) International application number:
**PCT/JP2023/037673**

(87) International publication number:
**WO 2024/095769 (10.05.2024 Gazette 2024/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.11.2022 JP 2022176336**
**31.05.2023 JP 2023089928**

(71) Applicant: **AGC INC.**
**Chiyoda-ku,**
**Tokyo 1008405 (JP)**

(72) Inventors:
- **SANO, Kohei**
**Tokyo 100-8405 (JP)**
- **ONO, Yoshitaka**
**Tokyo 100-8405 (JP)**
- **HAYASHI, Yasuo**
**Tokyo 100-8405 (JP)**

(74) Representative: **Müller-Boré & Partner Patentanwälte PartG mbB**
**Friedenheimer Brücke 21**
**80639 München (DE)**

(54) **METHOD FOR MANUFACTURING MEMBER HAVING CONCAVE STRUCTURE, AND MEMBER HAVING CONCAVE STRUCTURE**

(57) A method for manufacturing a member with a recess structure, comprises: (1) a step of placing a catalytic material on a part of a first surface of an object to be processed, the first surface being formed of an element of which a boiling point of a fluoride is 550°C or lower, and the catalytic material containing an organic compound containing a polar functional group; (2) a step of irradiating the catalytic material with irradiation light containing deep ultraviolet light having a wavelength of 380 nm or shorter; and (3) a step of exposing the object to be processed to a fluorine-containing gas at 80°C or higher, wherein a recess structure is formed under the catalytic material on the first surface after the step (3).

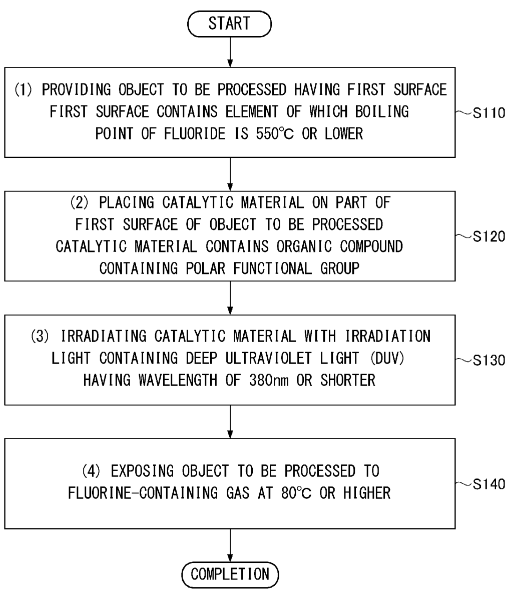


Fig. 7

EP 4 614 550 A1

# Description

## Technical Field

The present disclosure relates to a method for manufacturing a member with a recess structure and a member with a recess structure.

## Background Art

There are needs for a micromachining technique by which a microscopic recess structure can be formed on the surface of a sample in various fields. As such a micromachining technique, various methods have been proposed and put into practical use in the past.

One of such micromachining techniques is a dry etching method, in which a surface of a sample is etched by using a reactive material such as a reactive gas, ions, and/or radicals.

For example, in a reactive ion etching (RIE) method typified by inductive coupled plasma-RIE (ICP-RIE: Inductive Coupled Plasma-RIE), etching is performed by bringing an etching gas into a plasma state and striking the plasma gas against a sample. It has been reported that such an RIE method makes it possible to perform extremely microscopic machining on a sample (e.g., Non-patent Literature 1).

## Citation List

### Non Patent Literature

Non-patent Literature 1: xiao Li, King Yuk Chan and Rodica Ramer, "Fabrication of Through via Holes in Ultra-Thin Fused SilicaWafers for Microwave and Millimeter-Wave Applications," micromachines, 2018, 9, 138

## Summary of Invention

### Technical Problem

However, in the RIE method, there is a problem that when a recess structure is formed on a surface of a sample, a tapered shape is likely to be formed on the sidewall thereof, so that it is difficult to form a recess structure close to an ideal shape (vertical structure).

The present invention has been made in view of such a background, and an object thereof is to provide a method by which a member with a nearly vertical recess structure can be manufactured relatively easily. Further, another object of the present invention is to provide a member with a recess structure.

### Solution to Problem

The present invention provides a method for manufacturing a member with a recess structure, comprising:

(1) a step of placing a catalytic material on a part of a first surface of an object to be processed, the first surface being formed of an element of which a boiling point of a fluoride is 550°C or lower, and the catalytic material containing an organic compound containing a polar functional group;
(2) a step of irradiating the catalytic material with irradiation light containing deep ultraviolet light having a wavelength of 380 nm or shorter; and
(3) a step of exposing the object to be processed to a fluorine-containing gas at 80°C or higher, wherein

a recess structure is formed under the catalytic material on the first surface after the step (3).

Further, the present invention also provides a method for manufacturing a member with a recess structure, comprising:

(1) a step of placing a catalytic material on each of a first area and a second area on a first surface of an object to be processed, the first surface being formed of an element of which a boiling point of a fluoride is 550°C or lower, the catalytic material containing an organic compound containing a polar functional group, and the catalytic material placed in the second area is thicker than the catalytic material placed in the first area;
(2) a step of irradiating the catalytic material with irradiation light containing deep ultraviolet light having a wavelength of 380 nm or shorter; and

(3) a step of exposing the object to be processed to a fluorine-containing gas at 80°C or higher, wherein

after the step (3), a first recess structure is formed under the catalytic material in the first area on the first surface, and a second recess structure is formed under the catalytic material in the second area thereon, and
the second recess structure is deeper than the first recess structure.

Further, the present invention also provides a member with a recess structure on a first surface, wherein

the recess structure is a bottomed structure and/or a penetrating structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recess structure is defined by a first opening formed on the first surface, a peripheral sidewall, and a bottom surface or a second opening, and
the sidewall has surface roughness (arithmetic average roughness Ra) of 5 nm or finer.

## Advantageous Effects of Invention

According to the present invention, it is possible to provide a method by which a member with a nearly vertical recess structure can be manufactured relatively easily. Further, according to the present invention, it is also possible to provide a member with a recess structure.

## Brief Description of Drawings

Fig. 1 schematically shows a reaction mechanism that can occur on a first surface of an object to be processed when its organic compound has no polar functional group;
Fig. 2 schematically shows a reaction mechanism that can occur on a first surface of an object to be processed when its organic compound has a polar functional group;
Fig. 3 schematically shows a reaction mechanism that can occur on a first surface of an object to be processed when its organic compound has another type of polar functional group;
Fig. 4 is a graph showing a relationship between a processing temperature and an etching reaction rate when hydrogen fluoride (HF) gas etching is performed on glass;
Fig. 5 is a cross-sectional diagram schematically showing one process in a method according to an embodiment of the present invention;
Fig. 6 is a cross-sectional diagram schematically showing one process in a method according to an embodiment of the present invention;
Fig. 7 schematically shows a flow of a method for manufacturing a member with a recess structure according to an embodiment of the present invention;
Fig. 8 is a perspective view schematically showing a state where a catalytic material is placed on an object to be processed in a method for manufacturing a member with a recess structure according to an embodiment of the present invention;
Fig. 9 is a cross-sectional diagram schematically showing an example of an object to be processed after an etching process is performed in a method for manufacturing a member with a recess structure according to an embodiment of the present invention;
Fig. 10 is a perspective view of a member according to an embodiment of the present invention;
Fig. 11 is a cross-sectional diagram of the member according to the embodiment of the present invention shown in Fig. 10, taken along a line A-A shown in Fig. 10;
Fig. 12 schematically shows a form of a surface of a sidewall of a recess structure in a member according to an embodiment of the present invention;
Fig. 13 is a schematic view for explaining a taper angle $\theta$ of a recess structure;
Fig. 14 schematically shows a flow of a method for manufacturing a member with a recess structure according to another embodiment of the present invention;
Fig. 15 is a perspective view schematically showing a state where a catalytic material is placed on an object to be processed in a method for manufacturing a member with a recess structure according to another embodiment of the present invention;
Fig. 16 is a cross-sectional diagram schematically showing an example of an object to be processed after an etching process is performed in a method for manufacturing a member with a recess structure according to another

embodiment of the present invention;

Fig. 17 is a photograph showing an example of a cross section of a recess structure according to an embodiment of the present invention (Sample 1);

Fig. 18 is a photograph showing an example of a cross section of a recess structure according to another embodiment of the present invention (Sample 2);

Fig. 19 is a photograph showing an example of a cross section of a recess structure according to still another embodiment of the present invention (Sample 3);

Fig. 20 is a photograph showing an example of a cross section of a recess structure according to still another embodiment of the present invention (Sample 4);

Fig. 21 is a photograph showing an example of a cross section of a recess structure according to still another embodiment of the present invention (Sample 5);

Fig. 22 is a graph showing a relationship between an irradiation amount P of irradiation light and an etching rate, obtained by an embodiment of the present invention;

Fig. 23 is a graph showing a relationship between the thickness of a catalytic material and an etching rate; and

Fig. 24 is a photograph showing an example of a cross section of a recess structure according to another embodiment of the present invention (Sample 34).

## Description of Embodiments

Embodiments according to the present invention will be described hereinafter.

As described above, in the RIE method in the related art, there is a problem that when a recess structure is formed on a surface of a sample, a "tapered shape" is likely to be formed on the sidewall of the recess structure, so that it is difficult to form a nearly vertical recess structure.

Note that the "tapered shape" means a shape in which a sidewall defining a recess structure is inclined from an extension axis in the depth direction of the recess structure. For example, in the case where the recess structure has a bottomed structure, the recess structure having a "tapered shape" has such a form that the cross section of the recess structure becomes smaller toward the bottom thereof.

In order to cope with such a problem in the related art, the inventors of the present application have earnestly carried out research and development, and have found a micromachining technique by which a nearly vertical recess structure can be formed more easily.

This new micromachining technique (hereinafter referred to as a "first machining technology") developed by the inventors of the present application includes a process in which an object to be processed on which a catalytic material placed on its first surface is exposed to a fluorine-containing gas at a processing temperature of 80°C or higher (hereinafter referred to as an "etching process"). As will be described in detail later, by performing such an "etching process", the first machining technology makes it possible to selectively etch an area in which the catalytic material is placed (hereinafter referred to as a "covered area") on the first surface of the object to be processed.

However, according to additional research made by the inventors of the present application, the etching rate for the object to be processed tends to become extremely high, for example, 20 nm/sec, in the first machining technology. Although such a high etching rate is desirable for speedy machining of an object to be processed, it could cause a problem when relatively shallow machining is performed on an object to be processed. This is because when the etching rate is extremely high, it is difficult to accurately stop the etching at a predetermined machining depth.

The inventors of the present application have also earnestly conducted research on such a problem related to the first machining technology. Then, the inventors have found that by irradiating a catalytic material with specific irradiation light before carrying out an etching process on an object to be processed, the etching rate in the subsequent etching process can be controlled, and have achieved the present invention.

That is, according to an embodiment of the present invention, a method for manufacturing a member with a recess structure comprises:

(1) a step of placing a catalytic material on a part of a first surface of an object to be processed, the first surface being formed of an element of which a boiling point of a fluoride is 550°C or lower, and the catalytic material containing an organic compound containing a polar functional group;

(2) a step of irradiating the catalytic material with irradiation light containing deep ultraviolet light having a wavelength of 380 nm or shorter; and

(3) a step of exposing the object to be processed to a fluorine-containing gas at 80°C or higher, wherein

a recess structure is formed under the catalytic material on the first surface after the step (3).

A method according to an embodiment of the present invention will be described hereinafter in a more detailed manner with reference to the drawings.

Firstly, in order to facilitate the understanding of a method according to an embodiment of the present invention, the role of the catalytic material in the above-described first machining technology and the effect of the processing temperature will be described.

Note that although the following description is based on a mechanism that is currently presumed, actual phenomena may occur based on other mechanisms.

(Role of Catalytic Material)

In the first machining technology, a catalytic material contains an organic compound containing a polar functional group. It is considered that such an organic compound containing a polar functional group has a role of lowering the activation energy of the formation of a fluoride on the surface of the object to be processed.

This role will be described hereinafter with reference to Figs. 1 to 3. Figs. 1 to 3 schematically show how the reaction proceeds on the surface of the object to be processed on which the catalytic material is placed.

Note that in the following description, it is assumed, as an example, that the object to be processed is made of $SiO_2$, and that the surface to be processed (first surface) of the object to be processed is hydrogen-terminated.

Firstly, Fig. 1 schematically shows an etching mechanism assumed on the first surface of the object to be processed when its organic compound has no polar functional group.

When a hydrogen fluoride (HF) gas is supplied from the environment to an area in which the catalytic material is placed, i.e., to the "covered area", on the surface of $SiO_2$, of which the object to be processed is made, the HF molecule (a) makes a nucleophilic attack on the Si atom (b) as expressed by the below-shown Formula (i).

However, in order to make the Si atom (b) react with the F atom on the surface of the object to be processed, it is necessary that the OH group (c) on the surface interact with the H atom of the HF molecule (a), and the H-F bond be thereby weakened as expressed by Formula (ii). That is, unless energy for breaking the H-F bond in the HF molecule (a) is supplied, the Si-F bond (d), which involves the elimination of $H_2O$ (g) as expressed by Formula (iii), is not formed.

However, in this reaction system, there is no material that contributes to the decrease in the activation energy of the Si-F bond (d). Therefore, no meaningful etching reaction proceeds in the covered area.

Note that in this system, the etching rate tends to increase in the part where the object to be processed is in direct contact with the HF gas, i.e., in the area where no catalytic material is placed (hereinafter referred to as an "uncovered area") on the surface as in the ordinary mask pattern process.

Meanwhile, Fig. 2 schematically shows a reaction mechanism on the first surface of the object to be processed when its organic compound has a polar functional group. In this example, it is assumed that the polar functional group is a hydroxy group.

Even in this case, when an HF gas is supplied from the environment to the area covered by the catalytic material, the HF molecule (a) also makes a nucleophilic attack on the Si atom (b) as expressed by Formula (i).

However, in this case, in addition to this attack, the O atom of the $-\delta$ part (e) of the polar functional group interacts with H of the HF molecule (a). Further, the H atom of the $+\delta$ part (f) of the polar functional group interacts with the OH group (c) present on the surface.

Therefore, as expressed by Formula (ii), the H-F bond of the HF molecule (a) is weakened. Further, the bond between Si (b) and OH (c) is also weakened. As a result, the activation energy required for the bonding reaction between the Si atom and the F atom is lowered.

As a result, as expressed by Formula (iii), the H atom of the HF molecule (a) is taken away by the O atom of the $-\delta$ part (e) of the polar functional group, and the H atom of the $+\delta$ part (f) reacts with the OH group present on the surface, so that $H_2O$ (g) is eliminated.

As a result, the Si atom (b) is bonded to the fluorine atom. Eventually, $SiF_4$ and $H_2O$ are formed as expressed by the below-shown Reaction Formula (1).

$$SiO_2 + 4HF \rightarrow SiF_4\uparrow + 2H_2O\uparrow \qquad (1)$$

Both $SiF_4$ and $H_2O$ generated by the reaction are gases at the processing temperature and are rapidly dispersed to the outside of the system.

By the above-described reaction mechanism, the part of the object to be processed located directly below the area covered by the catalytic material is selectively etched.

Note that the above-described reaction is not limited to those in the case where the polar functional group contains a hydroxy group. For example, a similar reaction can occur when the polar functional group contains at least one of an aldehyde group, a hydroxy group, a carboxy group, an amino group, a sulfo group, a thiol group, and an amide bond.

Further, in Fig. 2, the reaction mechanism has been described by using an example case where the polar functional group of the organic compound contains an H atom. However, the polar functional group of the organic compound is not limited to those containing an H atom.

Fig. 3 schematically shows a reaction mechanism when the organic compound contains another type of polar functional group. In this example, it is assumed that the polar functional group is a carbonyl group having no H atom (>C=O).

Even in this example, when an HF gas is supplied from the environment to the area covered by the catalytic material, the HF molecule (a) also makes a nucleophilic attack on the Si atom (b) as expressed by Formula (i). Further, the O atom of the -δ part (e) of the polar functional group interacts with the H atom of the HF molecule (a).

As a result, as expressed by Formula (ii), the H-F bond of the HF molecule (a) is weakened.

Next, as expressed by Formula (iii), the H atom separated from the HF molecule (a) by the O atom of the -δ part (e) of the polar functional group binds with the OH group (c), so that $H_2O$ (g) is generated.

As described above, even in this case, the activation energy required for the bonding reaction between the Si atom and the F atom is lowered. As a result, the reaction expressed by the above-described Reaction Formula (1) occurs, and hence the part of the object to be processed located directly below the covered area is selectively etched.

A similar reaction mechanism can occur when the polar functional group has, for example, at least one of a carbonyl group, a nitro group, a cyano group, an ether bond, and an ester bond.

As described above, in the first machining technology, because of the presence of the organic compound containing the polar functional group, which is contained in the catalytic material, the fluoride generation reaction is expedited in the covered area on the object to be processed, so that the part directly below the covered area can be selectively etched.

(Effect of Processing Temperature)

Next, the effect of the processing temperature will be described.

In the first machining technology, the processing temperature is 80°C or higher. This is because when the temperature is lower than 80°C, proper etching selectivity is not obtained between the covered area and the uncovered area on the first surface of the object to be processed.

The effect of the processing temperature will be described hereinafter in detail with reference to Fig. 4.

Fig. 4 shows a relationship between the processing temperature and the etching reaction rate when hydrogen fluoride (HF) gas etching is performed on glass, acquired by the inventors of the present application.

From Fig. 4, when the processing temperature is lower than 80°C, the etching rate in the glass gradually increases as the temperature rises. However, when the processing temperature rises to 80°C or higher, the etching rate sharply decreases. As a result, the etching rate has a peak at a temperature lower than 80°C.

It is presumed that this phenomenon corresponds to the association/non-association state of the HF gas. That is, while the HF gas is in the association state when the processing temperature is lower than 80°C, it is in the non-association state (simple substance) when the processing temperature is equal to or higher than 80°C. Further, when attention is paid to one molecule, when the HF gas is in the association state, the binding force of the H-F bond is relatively weak. Therefore, the F atom of the HF molecule easily binds with the surface of the object to be processed, and thereby easily forms a fluoride. It is presumed that because of such behavior, a high etching rate can be easily obtained at a temperature lower than 80°C.

In the first machining technology, if the processing temperature is set to a temperature lower than 80°C, the association state of the HF gas is affected, so that the area not covered by the catalytic material on the object to be processed is etched. Therefore, the etching selectivity in the covered area by the above-described reaction mechanism deteriorates.

In contrast, when the processing temperature is set to 80°C or higher, the high etching force caused by the HF gas which is in the association state can be suppressed in the area not covered by the catalytic material. Further, based on the above-described reaction mechanism, etching can be performed on the part directly below the covered area on the object to be processed. As a result, high etching selectivity can be obtained between the area covered by the catalytic material and the area not covered by the catalytic material at the processing temperature equal to or higher than 80°C. Further, because of this high etching selectivity, the covered area can be selectively etched in the first machining technology.

(Recessed Structure to be Formed)

In the RIE method in the related art, a "tapered shape" is likely to be formed on the sidewall of the recess structure, so that it is difficult to form a nearly vertical recess structure.

In contrast to this, in the first machining technology, a recess structure having a sidewall that does not have a "tapered shape" and extends substantially parallel to an extension axis in the depth direction (hereinafter referred to as a "vertical recess structure") can be formed relatively easily.

The reason for this feature will be described hereinafter with reference to Figs. 5 and 6.

Each of Figs. 5 and 6 schematically shows one process in the first machining technology.

Fig. 5 schematically shows a state where a catalytic material 3 is placed on a surface of an object to be processed 1. Note that the object to be processed 1 and the catalytic material 3 are shown as if they are separated from each other in Figs. 5 and 6 for the sake of visual explanation, in reality, they are in contact with each other.

As described above, it is assumed that the object to be processed 1 is made of $SiO_2$, and the surface is H-terminated.

The catalytic material 3 is an organic compound containing a polar functional group. Further, in this example, it is assumed that the polar functional group is an OH group. A covered area 8a and an uncovered area 8b are formed on the object to be processed 1 by placing the catalytic material 3 on the surface of the object to be processed 1.

As described above, etching selectively proceeds directly below the covered area 8a, where the catalytic material 3 is placed, by exposing the object to be processed 1, which is heated to 80°C or higher, to an HF gas. As a result, a recess structure is formed directly below the covered area 8a.

Fig. 6 shows a state where the etching of the object to be processed 1 has proceeded to some extent and a recess structure 5 having a certain depth has been formed.

As described above, the catalytic material 3 is placed in the covered area 8a. Therefore, even when the etching reaction has proceeded, the catalytic material 3 still exists on the bottom surface 6 of the recess structure 5. That is, while the etching process is continued, the bottom surface 6 of the recess structure 5 is continuously in contact with the catalytic material 3. Therefore, the bottom surface 6 of the recess structure 5 is continuously etched by the reaction mechanism described above, and the bottom surface 6 continuously proceeds in the depth direction.

Meanwhile, when attention is paid to the sidewall 7 of the recess structure 5, once the etching is started, the etching reaction proceeds in the part of the sidewall 7 that is in contact with the catalytic material 3 according to the mechanism described above. More precisely, only the part that is in contact with the side surface of the catalytic material 3 of the object to be processed 1 is etched. As a result, the recess structure 5 defined by the sidewall 7 is formed in the place that is in contact with the side surface of the catalytic material 3.

However, since the catalytic material 3 is continuously lowered deeper and deeper, the upper part of the sidewall 7 is no longer in contact with the side surface of the catalytic material 3 at and after a certain time point. In the following description, the part of the sidewall 7 that is no longer in contact with the side surface of the catalytic material 3 is referred to as a "first sidewall part 7a".

Note that as described above, etching substantially does not proceed in the place where the catalytic material 3 no longer exists, such as in the uncovered area 8b. In other words, in the object to be processed 1, the etching reaction occurs only when it is in contact with the catalytic material 3, and does not occur in the other states. Therefore, in the sidewall 7, in the place that is no longer in contact with the catalytic material 3, such as in the first sidewall part 7a, the etching process substantially stops thereafter.

This is a feature that is definitively different from the dry etching method such as the RIE method in the related art. That is, in the RIE method, during the etching process, even an area where the etching has already been completed, such as the vicinity of the opening on the surface of the objected to be processed, is still continuously exposed to the reaction gas. Therefore, there is a high possibility that a recess structure having a tapered shape is formed as the etching process is continued.

In the first machining technology, as a result of the etching stopping action at the first sidewall part 7a, which is no longer in contact with the catalytic material 3 as described above, the etching of the object to be processed 1 selectively proceeds only in the part directly below the catalytic material 3, so that eventually, a vertical recess structure can be formed.

As a result of the above-described effect, a characteristic vertical recess structure can be formed as a recess structure 5 in the first machining technology.

However, in the first machining technology, the etching rate for the object to be processed tends to be extremely high, for example, 20 nm/sec. Although such a high etching rate is desirable for speedy machining of an object to be processed, it could cause a problem when a relatively shallow recess is machined on an object to be processed. This is because when the etching rate is extremely high, it is difficult to accurately stop the etching at a predetermined machining depth.

However, the method according to an embodiment of the present invention includes a step of irradiating the catalytic material with irradiation light containing deep ultraviolet light (DUV) having a wavelength of 380 nm or shorter (hereinafter referred to as a "DUV irradiation step") before carrying out the etching process for the object to be processed. When such a DUV irradiation step is added, the etching rate of the object to be processed can be controlled in the subsequent etching process.

Note that it is presumed that in the method according to an embodiment of the present invention, the etching rate of the object to be processed can be controlled by carrying out the etching process after carrying out the DUV irradiation step because the number of polar functional groups changes by the DUV irradiation step.

This phenomenon will be described hereinafter by referring to Fig. 5 again.

As shown in Fig. 5, when the catalytic material 3 is placed on the surface of the object to be processed 1, a covered area 8a and an uncovered area 8b are formed on the object to be processed 1.

Because of the presence of the catalytic material 3, the reaction barrier in Reaction Formula (1) is lowered in the covered area 8a as described above, so that the etching selectively proceeds in the covered area 8a during the etching process.

However, when the DUV irradiation step is performed, a crosslinking reaction occurs in the catalytic material 3 as a result of exposure to the deep ultraviolet light having a wavelength of 380 nm or shorter. By the crosslinking reaction, the number of polar functional groups (e.g., C-OH groups) contained in the catalytic material 3 decreases. Therefore, it is presumed that during the subsequent etching process, the effect for reducing the reaction barrier in the above-described Reaction Formula (1) is weakened, and hence the etching rate decreases.

Further, in this case, the number of polar functional groups contained in the catalytic material 3 is also changed by changing the irradiation intensity of the irradiation light containing deep ultraviolet light and the irradiation time of the irradiation light in the DUV irradiation step. Therefore, in the etching process, the etching rate of the object to be processed 1 can be controlled by changing the irradiation conditions in the DUV irradiation step.

For example, in the case where a relatively shallow recess structure is formed, the irradiation intensity of the irradiation light may be increased and/or the irradiation time may be increased in the DUV irradiation step. As a result, the etching rate in the etching process can be meaningfully lowered, so that over-etching for the object to be processed can be prevented.

Further, in the case where a relatively deep recess structure is formed, the irradiation intensity of the irradiation light may be lowered and/or the irradiation time may be shortened in the DUV irradiation step. As a result, the etching rate in the etching process can be increased, so that the machining time can be shortened.

As described above, in a method according to an embodiment of the present invention, a member with a nearly vertical recess structure can be manufactured at various etching rates.

Further, in the RIE method in the related art, the etching depth for $SiO_2$ is limited, so that there is a problem that, for example, it is difficult to precisely form a deep vertical recess structure of 20 μm or deeper when a photoresist is used as a masking agent.

However, in an embodiment according to the present invention, the etching reaction proceeds as long as the supply of the fluorine-containing gas to the covered area is continued. Therefore, a recess structure having a high aspect ratio can be formed. For example, an aspect ratio of 10 or higher can be achieved.

Note that the "aspect ratio" means the length of the recess structure in the depth direction relative to the minimum dimension of the opening of the recess structure.

(Method for manufacturing member with recess structure according to embodiment of present invention)

Next, a method for manufacturing a member with a recess structure according to an embodiment of the present invention will be described in a more detailed manner with reference to Figs. 7 to 9.

Fig. 7 schematically shows a flow of a method for manufacturing a member with a recess structure according to an embodiment of the present invention (hereinafter also referred to simply as the "first method").

As shown in Fig. 7, the first method comprises:

(1) a step (S110) of preparing an object to be processed including a first surface, in which the first surface contains an element of which a boiling point of a fluoride is 550°C or lower;
(2) a step (S120) of placing a catalytic material on a part of the first surface of the object to be processed, in which the catalytic material contains an organic compound containing a polar functional group;
(3) a step (S130) of irradiating the catalytic material with irradiation light containing deep ultraviolet light (DUV) having a wavelength of 380 nm or shorter; and
(4) a step (S140) of exposing the object to be processed to a fluorine-containing gas at 80°C or higher.

Each of the steps will be described hereinafter.

(Step S110)

Firstly, an object to be processed is prepared.

The object to be processed may be formed of one member or may be formed of a plurality of members.

When the object to be processed is formed of one member, the object to be processed is formed of an element of which a fluoride having a boiling point of 550°C or lower is formed by a reaction with fluorine (F).

For example, the object to be processed may contain at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. Further, the object to be processed may also contain at least one element selected from the group consisting of H, N, Cl, Br, and O.

In particular, the object to be processed is preferably formed of an element of which a fluoride having a boiling

point of 200°C or lower is formed by a reaction with fluorine.

For example, regarding silicon (Si), its fluoride $SiF_4$ has a boiling point of -86°C, so that an object to be processed containing silicon can be suitably used as the object to be processed in the first method.

Note that regarding Al and Ca, the boiling points of their fluoride ($AlF_3$) and ($CaF_2$) both exceed 550°C. Therefore, Al and Ca cannot be regarded as elements of which a fluoride having a boiling point of 550°C or lower is formed by a reaction with fluorine (F).

The object to be processed may be, for example, a quartz glass substrate, a crystal substrate, or a silicon substrate.

Meanwhile, when the object to be processed is formed of a laminate of a plurality of members, the object to be processed contains an element of which the boiling point of the fluoride is 550°C or lower on the outermost surface (hereinafter referred to as the "first surface") thereof.

As described above, such an element may be selected from, for example, the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. Further, the first surface may contain at least one element selected from the group consisting of H, N, Cl, Br, and O.

For example, the object to be processed may include one or more films placed on the substrate, and the outermost surface film may have the above-described features. Alternatively, all of the plurality of films may have the above-described features.

Such a film may contain, for example, at least one of $SiO_2$, $Si_3N_4$, and SiC.

Alternatively, the substrate as well as the film may have the above-described features. **In** this case, a member with a recess structure which is formed deeply inside the substrate can be manufactured by the first method. The substrate may be, for example, a quartz glass substrate, a crystal substrate, or a silicon substrate.

Note that in the following description, in order to prevent the explanation from becoming complicated, it is assumed that the object to be processed is formed of one quartz glass, and a recess structure is formed on a first surface of this quartz glass.

(Step S120)

Next, a catalytic material is placed on the first surface of the object to be processed. The catalytic material is placed in a predetermined area on the first surface.

The catalytic material includes an organic compound containing a polar functional group. The polar functional group may contain, for example, at least one group or bond selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

Typical examples of such organic compounds include phenolic resins, acrylic resins, and methacrylic resins.

The catalytic material may be formed of only the organic compound containing a polar functional group described above, or may be provided as a mixture with other additives.

In the latter case, the catalytic material may contain a solvent, a binder, and/or fine particles.

The method for placing a catalytic material is not limited to any particular methods.

The catalytic material may be placed on the first surface of the object to be processed by using, for example, a coating method, a printing method, a spin coating method, or a spray method.

Fig. 8 schematically shows a state where the catalytic material is placed on the object to be processed.

As shown in Fig. 8, the object to be processed 110 includes a first surface 112 and a second surface 114. Catalytic materials 130 (i.e., pieces of catalytic material 130) are placed on parts of the first surface 112 of the object to be processed 110.

Note that in the example shown in Fig. 8, the catalytic materials 130 are placed in the form of a pattern 131 consisting of a plurality of parallel lines. However, this pattern is merely an example, and the catalytic materials 130 may be placed in any form according to the required recess structure. The catalytic materials 130 may be disposed, for example, in the form of one straight line. Alternatively, the catalytic materials 130 may be arranged, for example, as a pattern consisting circular dots or may be disposed as one circular dot.

The thickness of the catalytic materials 130 is not limited to any particular values, and may be, for example, in a range of 0.1 μm to 4 μm. According to the above-described definition, on the first surface 112, the areas where the catalytic materials 130 are placed are referred to as a covered area 140a, and the remaining area is referred to as an uncovered area 140b.

(Step S130)

Next, the catalytic materials 130 are irradiated with irradiation light. The irradiation light contains deep ultraviolet light (DUV) having a wavelength of 380 nm or shorter. The wavelength of the deep ultraviolet light may be in a range of 200

nm to 365 nm.

In a typical case, the irradiation light is emitted from a light source. Such a light source may be a light source that emits light having one wavelength (or one wavelength range) or a light source that emits light having a plurality of wavelengths (or a plurality of wavelength ranges).

The irradiation conditions such as the irradiation intensity and irradiation time of the irradiation light are determined based on the etching rate that will be adopted in a step S140 performed later. That is, as the irradiation intensity of the irradiation light is increased and the irradiation time thereof is increased, the etching rate of the object to be processed in the step S140 decreases.

For example, the irradiation amount P ($mJ/cm^2$) of the irradiation light may be 20 $mJ/cm^2$ or larger.

Note that the irradiation amount P of the irradiation light is expressed by the below-shown Expression (2):

$$\text{Irradiation amount P } (mJ/cm^2) = \text{Irradiation intensity of Lamp A } (mW/cm^2) \times \text{Irradiation time (sec) (2)} \qquad (2)$$

(Step S140)

Next, the object to be processed 110, in which the catalytic materials 130 have been placed, is put in a processing chamber. After that, for the etching process of the object to be processed, the inside of the processing chamber is heated to a predetermined temperature, and a processing gas is supplied thereto.

The processing gas includes a hydrogen fluoride gas or a fluorine gas. For example, the concentration of the processing gas may be adjusted to a predetermined concentration by using a carrier gas such as an argon gas or a nitrogen gas. **In** this case, the concentration of the hydrogen fluoride gas or fluorine gas may be, for example, in a range of 0.1 vol% to 100 vol%.

As described above, the processing temperature is 80°C or higher. The actual processing temperature changes depending on the elements contained in the object to be processed 110 (in particular, the first surface 112), and the type, the depth, and the like of the recess structure. However, in a typical case, the processing temperature is in a range of 200°C to 450°C, and preferably in a range of 250°C to 400°C. By setting the processing temperature to 450°C or lower, the degradation of the organic compound contained in the catalytic materials 130 can be suppressed.

As described above, the above-described Reaction Formula (1) occurs in the covered area 140a by performing the etching process on the object to be processed 110 under the above-described environment. Further, the fluoride and water generated by the reaction become gases and are dispersed to the outside of the system. As a result, a recess structure is formed in the covered area 140a on the first surface 112.

The recess structure may be a bottomed structure or a penetrating structure. The bottomed structure may be, for example, a bottomed hole and/or a bottomed groove. Further, the penetrating structure may be a penetrating hole or a penetrating groove.

Fig. 9 schematically shows an example of a cross section of the object to be processed 110 after the etching process.

In the example shown in Fig. 9, recess structures 150 are formed as grooves, and in the plan view, the grooves extend in parallel to each other. In this example, the grooves extend in the depth direction from the first surface 112, but do not reach the second surface 114, so that they are bottomed grooves.

Note that a step of removing the catalytic materials 130 remaining on the bottom surfaces of the recess structures 150 may be performed after the step S140. For example, the catalytic materials 130 may be removed by cleaning the object to be processed 110 with an acid solution, an alkali solution, an organic solvent, a corrosive gas, or plasma.

Through the above-described steps, a member 100 with recess structures 150 formed on the first surface 112 can be manufactured.

As described above, in the first machining technology, the etching rate for the object to be processed can become extremely high. Therefore, in the first machining technology, it is difficult to form a shallow recess structure 150 having an accurate depth.

However, in the first method as described above, it is possible to adjust the etching rate of the object to be processed in the step S140 by controlling the irradiation conditions of the irradiation light in the step S130.

Therefore, in the first method, nearly vertical recess structures 150 can be formed irrespective of the depth of the recess structures 150.

The depth of the recess structures 150 is, for example, 10 μm or shallower, or may be 5 μm or shallower. Alternatively, the depth of the recess structures 150 may be, for example, 20 μm or deeper, or may be 100 μm or deeper.

(Member with recess structure according to embodiment of present invention)

Next, a member with recess structures according to an embodiment of the present invention will be described with reference to Figs. 10 to 13.

Fig. 10 is a perspective view of a member with recess structures according to an embodiment of the present invention (hereinafter referred to as a "first member 300"). Further, Fig. 11 is a cross-sectional diagram of the first member 300 shown in Fig. 10, taken along a line A-A shown in Fig. 10.

As shown in Fig. 10, the first member 300 includes a first surface 302 and a second surface 304 which face each other. Further, the first member 300 includes recess structures 350 on the side thereof on which the first surface 302 is located.

Note that in the example shown in Fig. 10, the first and second surfaces 302 and 304 of the first member 300 have substantially rectangular shapes. However, the shapes of the first and second surfaces 302 and 304 are not limited to any particular shapes.

Further, in the example shown in Fig. 10, the recess structure 350, i.e., each of the recess structures 350, has a shape of a bottomed groove extending in one direction, and the three recess structures 350 are arranged in parallel to each other.

However, this arrangement is merely an example, and the shape and arrangement of the recess structures 350 are not limited to any particular shapes and arrangements. For example, the recess structures 350 may be bottomed structures or penetrating structures. The bottomed structure may be, for example, a bottomed hole and/or a bottomed groove. Further, the penetrating structure may be a penetrating hole or a penetrating groove. Similarly, the pattern of the recess structures 350 may be any pattern or the like.

As shown in Fig. 11, the recess structures 350 include openings 352 on the first surface 302. Further, the recess structures 350 also include bottom surfaces 356 and sidewalls 357. In other words, the recess structure 350, i.e., each of the recess structures 350, is defined by the opening 352, the bottom surface 356, and the sidewall 357.

The first member 300 can be manufactured by, for example, the first method described above.

Note that the first member 300 has such features that the sidewalls 357 of the recess structures 350 are relatively smooth and have surface roughness (arithmetic average roughness Ra) of 5 nm or finer. In particular, the surface roughness Ra of the sidewalls 357 are preferably 4.5 nm or finer, and more preferably 4.0 nm or finer.

These features will be described hereinafter.

As described above with reference to Figs. 5 and 6, in the first method, the covered area 8a is selectively etched owing to the catalytic material 3 placed on the covered area 8a. Further, as long as the relationship between the catalytic material 3 and the covered area 8a is maintained, the recess structure 5 continuously proceeds in the depth direction.

In the case of such an etching mechanism, the sidewall 7 of the recess structure 5 generated by the etching is affected by the state of the side surface of the catalytic material 3 with which the sidewall 7 is in contact.

In general, it is considered that the side surface of the catalytic material 3 is relatively smooth with few irregularities. Because of the effect of such few irregularities on the side surface of the catalytic material 3, the sidewall 7 of the recess structure 5 has a relatively smooth surface. As a result, it is expected that the sidewall 7 of the recess structure 5 has a surface of which the surface roughness is meaningfully suppressed.

Such smoothness is not observed in members subjected to etching processes in the related art and hence is meaningful. For example, in ordinary RIE methods, the sidewall of the recess is affected by the collisions of ions during the machining, and hence may have relatively large irregularities thereon.

Further, the first member 300 may have a feature that the sidewall 357 has a streak pattern extending in the depth direction.

This feature will be described hereinafter with reference to Fig. 12.

Fig. 12 schematically shows a form of the surface of the sidewall 357 of the recess structure 350. Fig. 12 schematically shows a part of the sidewall 357 that is obtained when the recess structure 350 is cut in such a manner that the cross section passes through an extension axis in a direction parallel to the first surface 302 of the first member 300 and an extension axis in the depth direction.

As shown in Fig. 12, in the first member 300, in the sidewall 357 of the recess structure 350, unbroken continuous streaks (hereinafter referred to as "continuous streaks") 380 extending from the opening 352 to the bottom surface 356 are formed.

Note that in Fig. 12, three continuous streaks 380 are shown. However, this is merely an example, and the number of streaks 380 is not limited to any particular numbers.

It is presumed that such a pattern of streaks 380 is also formed by the above-described mechanism.

That is, the sidewall 7 of the recess structure 5 generated by the etching is affected by the state of the side surface of the catalytic material 3 with which the sidewall 7 is in contact.

Further, in the first method, the catalytic material 3 having such irregularities on the side surface proceeds to the bottom surface 6 of the recess structure 5 in the depth direction of the recess structure 5. Therefore, a pattern of streaks 380 corresponding to such irregularities is likely to be also formed on the sidewall 7 of the eventually obtained recess structure 5.

It is presumed that, as a result, streaks extending in the depth direction are formed on the sidewall 357.

In addition to the above-described features, the first member 300 may have another feature that the taper angle $\theta$

of the recess structure 5 is in a range of 0° to 2°.

This feature will be described hereinafter with reference to Fig. 13.

Fig. 13 schematically shows a cross section of a certain recess taken along an extension axis L.

This recess 50 includes an opening 52 on the first surface of the member. Further, the recess 50 includes a bottom surface 56 and a sidewall 57.

Note that although it is not clearly shown in Fig. 13, the recess 50 may be a circular hole or a rectangular groove in the plan view. Further, the recess 50 may be a penetrating structure. In this case, the recess 50 may have a second opening instead of including the bottom surface 56.

For such a recess 50, the taper angle θ is defined as follows:

[Expression 1]

$$\text{Taper Angle } \theta\,(°) = \cos^{-1}\left(\frac{c}{\sqrt{\left(\frac{a-b}{2}\right)^2 + c^2}}\right) \qquad (3)$$

In the expression, a is the minimum dimension of the opening 52. Further, b is the minimum dimension of the bottom surface 56. Further, c is the distance between the first opening 52 and the bottom surface 56, i.e., the depth of the recess 50.

The taper angle θ expressed by Expression (3) serves as an index of the "vertical level" of the recess 50. That is, the smaller the taper angle θ is, the more the inclination of the sidewall 57 of the recess 50 from the extension axis L is suppressed, so that it can be said that such a recess 50 is close to the "vertical recess structure". In particular, when the taper angle θ of the recess structure 350 is in a range of 0° to 2° in the first member 300, it can be said that the recess structure 350 has the vertical recess structure.

In the first member 300, the taper angle θ of the recess structure 350 may be 1° or smaller.

Further, in the first member 300, the depth of the recess structure 350 may be 1 μm or deeper. In particular, in the first member 300, the depth of the recess structure 350 is, for example, 2 μm or deeper, and preferably 3 μm or deeper.

(Other Features of First Member 300)

The first member 300 may be formed of one member or may be formed of a plurality of members.

When the first member 300 is formed of one member, the first member 300 is formed of an element of which a fluoride having a boiling point of 550°C or lower is formed by a reaction with fluorine (F).

For example, the first member 300 may contain at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. Further, the object to be processed may also contain at least one element selected from the group consisting of H, N, Cl, Br, and O.

When the first member 300 is formed of one member, the first member 300 may be, for example, a quartz glass substrate or a crystal substrate.

Meanwhile, when the first member 300 is formed of a plurality of members, the first member 300 contains, on the first surface 302, an element of which a boiling point of a fluoride is 550°C or lower.

As described above, such an element may be selected from, for example, the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au. Further, the first surface 302 may also include at least one element selected from the group consisting of H, N, Cl, Br, and O.

For example, the first member 300 may have one or more films placed on the substrate material, and the outermost surface film may have the above-described features. Alternatively, all of the plurality of films may have the above-described features.

Such a film may contain, for example, at least one of $SiO_2$, $Si_3N_4$, and SiC. Alternatively, the substrate material as well as the film may have the above-described features.

The first member 300 having such features can be applied to, for example, various applications such as MEMS devices, micro-hydraulic devices, semiconductor devices, optical devices, meta-surface devices, molds for resin molding, window glasses, and cover glasses.

(Method for manufacturing member with recess structure according to other embodiment of present invention)

Next, a method for manufacturing a member with a recess structure according to another embodiment of the present invention will be described in a more detailed manner with reference to Figs. 14 to 16.

Fig. 14 schematically shows a flow of a method for manufacturing a member with a recess structure according to another embodiment of the present invention (hereinafter also referred to simply as the "second method").

As shown in Fig. 14, the second method comprises:

(1) a step (S210) of preparing an object to be processed including a first surface, in which the first surface contains an element of which a boiling point of a fluoride is 550°C or lower;
(2) a step (S220) of placing a catalytic material on a first area and a second area on the first surface of the object to be processed, in which the catalytic material contains an organic compound containing a polar functional group, and the catalytic material placed in the second area is thicker than the catalytic material placed in the first area;
(3) a step (S230) of irradiating the catalytic material with irradiation light containing deep ultraviolet light (DUV) having a wavelength of 380 nm or shorter; and
(4) a step (S240) of exposing the object to be processed to a fluorine-containing gas at 80°C or higher.

Each of the steps will be described hereinafter.

(Step S210)

Firstly, an object to be processed is prepared. Note that this step S210 is similar to the step S110 in the first method described above. Therefore, descriptions of details of the object to be processed are omitted here.

(Step S220)

Next, in at least two areas on the first surface of the object to be processed, catalytic materials having different thicknesses are respectively disposed.
Fig. 15 schematically shows an example of an object to be processed 410 after the step S220.
In the example shown in Fig. 15, catalytic materials 430 are respectively placed in three different areas on the first surface 412 of the object to be processed 410. That is, on the first surface 412 of the object to be processed 410, a first catalytic material 430-1 is placed in a first area 419-1; a second catalytic material 430-2 is placed in a second area 419-2; and a third catalytic material 430-3 is placed in a third area 419-3. Further, the third catalytic material 430-3 is thicker than the second catalytic material 430-2, and the second catalytic material 430-2 is thicker than the first catalytic material 430-1.
Note that the catalytic materials 430 having different thicknesses described above can be placed by, for example, a gray-scale exposure method. That is, in the case where an organic compound like the one described in the first method described above is adopted as each of the catalytic materials 430, it is possible to, by changing the irradiation intensity according to the place on the surface during the exposure process, form a pattern of the catalytic materials 430 having different thicknesses on the surface in the subsequent development process.

(Step S230)

Next, the first surface 412 of the object to be processed 410 is irradiated with irradiation light containing deep ultraviolet light.
Note that this step S230 is similar to the step S130 in the first method described above. Therefore, detailed description thereof is omitted here.

(Step S240)

Next, the object to be processed 410 is exposed to a fluorine-containing gas. Note that this step S240 is similar to the step S140 in the first method described above. Therefore, descriptions of process conditions and the like are omitted here.
However, it should be noted that in the second method, recess structures having different depths can be formed by the step S240.
Fig. 16 schematically shows an example of a cross section of the object to be processed 410 obtained after the step S240.
As shown in Fig. 16, three recess structures 450-1 to 450-3 are formed on the first surface 412 of the object to be processed 410. Among them, the first recess structure 450-1 is formed in the first area 419-1; the second recess structure 450-2 is formed in the second area 419-2; and the third recess structure 450-3 is formed in the third area 419-3. Further, the third recess structure 450-3 is formed deeper than the second recess structure 450-2, and the second recess structure 450-2 is formed deeper than the first recess structure 450-1.
Note that it is presumed that in the second method, the depths of the recess structures 450-1 to 450-3 formed after the step S240 differ from one another according to the thicknesses of the respective catalytic materials 430-1 to 430-3 placed in the step S220, because the amounts of polar functional groups contained in these catalytic materials 430-1 to 430-3 differ from one another after the DUV irradiation. That is, it is presumed that the amount of polar functional groups contained in the thin catalytic material 430-1 is smaller than that in the thick catalytic material 430-2 after the DUV

irradiation. Therefore, it is presumed in the first area 419-1 where the thin catalytic material 430-1 is placed, the etching rate in the step S240 is lowered, so that the recess structure 450-1 is shallower.

As described above, in the second method, the recess structures 450-1 to 450-3 having different depths can be formed by changing the thicknesses of the catalytic materials 430 placed in the respective areas 419-1 to 419-3 on the first surface 412 in the step S220.

## Examples

Examples according to the present invention will be described hereinafter. Note that in the following description, Examples 1 to 5 are examples according to the present invention, and Example 11 is a comparative example. Further, Examples 21-26 and 31-36 are examples according to the present invention, and Examples 41 and 42 are comparative examples.

(Example 1)

Recessed structures were formed on one of the surfaces (first surface) of an object to be processed by a method described hereinafter.

Firstly, a substrate made of quartz glass was prepared as an object to be processed. Further, a coating liquid containing a catalytic material was prepared. An i-line resist was used as the catalytic material, and the coating liquid was prepared by mixing the i-line resist with solvents (ethyl lactate and n-butyl acetate).

The used i-line resist contains a novolak resin represented by the below-shown chemical formula.

[Chemical Formula 1]

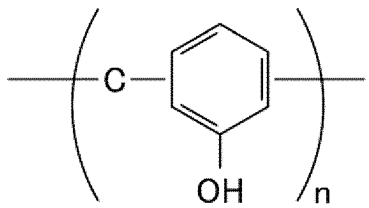

Therefore, the i-line resist contains a hydroxy group as the polar functional group.

Next, a coating liquid was placed on the first surface of the substrate by a spin coating method. Further, a pattern of the catalytic material was placed on the first surface of the substrate by exposure and a developing process. The pattern was a pattern of dots each having a diameter of about 10 μm.

Next, the pattern of the catalytic material was irradiated with irradiation light by using a low-pressure mercury lamp (hereinafter referred to as "Lamp A").

Lamp A was a DUV lamp having a main wavelength of 254 nm, and the irradiation amount P for the catalytic material was 72,000 mJ/cm$^2$.

Next, the substrate was cut into a piece having a size of about 20 mm × about 20 mm, and the cut sample was placed in a processing chamber in such a manner that the catalytic materials face upward. Further, a gas etching process was performed on the sample in the processing chamber. A mixed gas of a nitrogen gas and a hydrogen fluoride gas ($HF/N_2$ = 20 vol%) was used as the processing gas. The processing temperature was 250°C.

The object to be processed obtained after the etching process is referred to as "Sample 1".

In Sample 1, it was confirmed that a plurality of cylindrical grooves were formed as recess structures on the first surface of the substrate.

(Example 2)

Recessed structures were formed on the first surface of a substrate by a method similar to that in Example 1. However, in Example 2, the recess structures were formed with the irradiation amount P of the irradiation light different from that in Example 1.

The object to be processed obtained after the etching process is referred to as "Sample 2 ".

In Sample 2, it was confirmed that a plurality of cylindrical grooves were formed as recess structures on the first surface of the substrate.

(Example 3)

Recessed structures were formed on the first surface of a substrate by a method similar to that in Example 1. However, in Example 3, the pattern of the catalytic material was a pattern consisting of parallel lines having a pitch of about 30 μm in which the width of each line was about 10 μm.
Further, in Example 3, the pattern of the catalytic material was irradiated with irradiation light by using, instead of the Lamp A, a high-pressure mercury lamp (hereinafter referred to as "Lamp B"). Lamp B was a DUV lamp having a main wavelength of 365 nm, and the irradiation amount P for the catalytic material was 104,580 $mJ/cm^2$.
The object to be processed obtained after the etching process is referred to as "Sample 3".
In Sample 3, it was confirmed that a plurality of grooves extending parallel to each other were formed as recess structures on the first surface of the substrate.

(Examples 4 and 5)

In each of examples, recess structures were formed on the first surface of a substrate by a method similar to that in Example 3. However, in each of Examples 4 to 5, the recess structures were formed with the irradiation amount P of the irradiation light different from that in Example 3.
The objects to be processed obtained after the etching processes are referred to as "Samples 4" and "Samples 5", respectively.
In each of Samples 4 and 5, it was confirmed that a plurality of grooves extending parallel to each other were formed as recess structures on the first surface of the substrate.

(Example 11)

As described hereinafter, recess structures were formed on one of the surfaces (first surface) of an object to be processed by an ICP-RIE method.
A quartz glass substrate similar to that used in Example 1 was used as the object to be processed.
A mask pattern consisting of parallel lines having a thickness of about 7 μm was formed on the first surface of the substrate by a three-layer resist process.
Next, the first surface of the substrate was subjected to an etching process by the ICP-RIE method. As a result, an area where the mask pattern was not placed on the first surface was etched, so that a plurality of grooves extending parallel to each other were formed.
The object to be processed obtained after the process is referred to as "Sample 11".
The manufacturing conditions for the samples are summarized in Table 1 shown below.

[Table 1]

| Sample | Shape of pattern of catalytic material | Type of lamp | Irradiation amount P ($mJ/cm^2$) | Etching process |
|---|---|---|---|---|
| 1 | Dot | A | 72000 | hydrogen fluoride gas etching |
| 2 | Dot | A | 144000 | hydrogen fluoride gas etching |
| 3 | Line | B | 104580 | hydrogen fluoride gas etching |
| 4 | Line | B | 194220 | hydrogen fluoride gas etching |
| 5 | Line | B | 328680 | hydrogen fluoride gas etching |
| 11 | Line (3-layer resist mask) | - | - | RIE process |

(Evaluation)

In each sample, a cross section of the recess structure was observed by a scanning electron microscope (SEM), and various dimensions were measured. Further, the etching rates in the sample were calculated from the obtained results. Note that the etching rate was calculated by a formula "Depth of recess structure (nm)/Etching time (sec)". Further, the taper angles θ of the sidewalls of the recess structures were measured by the method described above.
The evaluation results obtained in the samples are summarized in Table 2 shown below.

[Table 2]

| Sample | Depth of recessed part (μm) | Etching rate (nm/sec) | Taper angle θ (° ) |
|---|---|---|---|
| 1 | 27.2 | 22.7 | 0 |
| 2 | 20.1 | 16.8 | 0 |
| 3 | 23.0 | 19.2 | 0 |
| 4 | 10.0 | 8.3 | 0 |
| 5 | 5.7 | 4.3 | 0 |
| 11 | 11.0 | 6.7 | 4.1 |

From Table 2, the taper angle θ of the recess structure of Sample 11 was relatively large, i.e., 4° or higher, and therefore it has been found that a tapered shape was formed in the recess structure of Sample 11. In contrast to this, it has been found that in each of Samples 1 to 5, a "vertical recess structure" in which the taper angle θ was meaningfully suppressed was formed as the recess structure.

Figs. 17 to 21 show examples of cross sections of recess structures obtained in Samples 1 to 5, respectively.

From Table 2, it can be seen that the etching rates of Samples 1 to 5 differ from one another. For example, in Sample 1 of which the recess was the deepest, an etching rate of 22.7 nm/sec was obtained. In contrast, in Sample 5 of which the recess was the shallowest, an etching rate of 4.3 nm/sec was obtained.

Fig. 22 collectively shows the measurement results of the etching rates obtained in Samples 1 to 5.

In Fig. 22, the horizontal axis indicates the irradiation amount P, and the vertical axis indicates the etching rate. Further, in Fig. 22, the dashed line represents results when the Lamp A was used, and the solid line represents results when the Lamp B was used.

From Fig. 22, it can be seen that for both of the lamps, the etching rate of the recess structure can be controlled by changing the irradiation amount P. In particular, it can be seen that there is a tendency that the etching rate decreases as the irradiation amount P is increased.

As described above, it has been confirmed that the etching rate of the recess structure can be controlled by changing the irradiation amount P applied to the catalytic material irrespective of the type of lamp.

(Example 21)

Recessed structures were formed on the first surface of an object to be processed by a method similar to that in Example 3.

However, in Example 21, three catalytic materials having thicknesses different from one another were placed on the respective areas on the first surface through a procedure described below.

Firstly, a coating liquid containing a catalytic material was placed on the first surface of the substrate by a spin coating method. The above-described i-line resist was used as the catalytic material.

Next, a pattern of the catalytic material consisting of three lines (10 μm in width) was placed on the first surface of the substrate by gray-scale exposure and the subsequent developing process.

The thickness of a first line of the pattern was 0.13 μm; the thickness of a second line of the pattern was 0.54 μm; and the thickness of a third line of the pattern was 1.22 μm.

After that, the substrate was irradiated with DUV by a method similar to that in Example 3. Note that the above-described low-pressure mercury lamp (Lamp A) was used for the DUV irradiation. The irradiation amount P was 72,000 mJ/cm$^2$ (hereinafter referred to as "Irradiation Amount A").

After that, an etching process similar to that in Example 3 was performed. As a result, three types of recess structures corresponding to the respective lines of the pattern were formed.

Hereinafter, the recess structure corresponding to the first line of the pattern is referred to as "Sample 21-1"; the recess structure corresponding to the second line of the pattern is referred to as "Sample 21-2"; and the recess structure corresponding to the third line of the pattern is referred to as "Sample 21-3".

(Example 22)

By a method similar to that in Example 21, four types of recess structures were formed in an object to be processed by using a pattern of a catalytic material consisting of four lines having thicknesses different from one another.

The obtained four recess structures are referred to as "Sample 22-1" to "Sample 22-4", respectively.

(Example 23)

By a method similar to that in Example 21, five types of recess structures were formed in an object to be processed by using a pattern of a catalytic material consisting of five lines having thicknesses different from one another. However, in Example 23, the irradiation amount P of DUV for the substrate was 144,000 mJ/cm$^2$ (hereinafter referred to as "Irradiation Amount B").

The obtained recess structures are referred to as "Samples 23-1" to "Sample 23-5", respectively.

(Example 24)

By a method similar to that in Example 21, five types of recess structures were formed in an object to be processed by using a pattern of a catalytic material consisting of five lines having thicknesses different from one another. However, in Example 24, the irradiation amount P of DUV for the substrate was 216,000 mJ/cm$^2$ (hereinafter referred to as "Irradiation Amount C").

The obtained recess structures are referred to as "Sample 24-1" to "Sample 24-5", respectively.

(Example 25)

By a method similar to that in Example 21, four types of recess structures were formed in an object to be processed by using a pattern of a catalytic material consisting of four lines having thicknesses different from one another. However, in Example 25, the irradiation amount P of DUV for the substrate was 216,000 mJ/cm$^2$ (hereinafter referred to as "Irradiation Amount D").

The obtained recess structures are referred to as "Samples 25-1" to "Sample 25-4", respectively.

(Example 26)

By a method similar to that in Example 25, three types of recess structures were formed in an object to be processed by using a pattern of a catalytic material consisting of three lines having thicknesses different from one another.

The obtained recess structures are referred to as "Samples 26-1" to "Sample 26-3", respectively.

(Evaluation)

The etching depth of each sample was measured by using an SEM. Further, for each sample, an average etching rate of the sample was calculated from the result obtained for the sample.

The thicknesses of the catalytic materials used in the respective samples and the evaluation results obtained therefor are summarized in Table 3 shown below.

[Table 3]

| Sample | Irradiation amount | Thickness of catalytic material (μm) | Etching rate (μm/min) |
|---|---|---|---|
| 21-1 | A | 0.13 | 0.04 |
| 21-2 | A | 0.54 | 0.57 |
| 21-3 | A | 1.22 | 0.83 |
| 22-1 | A | 0.34 | 0.23 |
| 22-2 | A | 0.81 | 0.76 |
| 22-3 | A | 1.55 | 0.86 |
| 22-4 | A | 2.02 | 0.86 |
| 23-1 | B | 0.34 | 0.07 |
| 23-2 | B | 0.54 | 0.18 |
| 23-3 | B | 1.28 | 0.38 |
| 23-4 | B | 1.71 | 0.59 |
| 23-5 | B | 2.11 | 0.71 |
| 24-1 | C | 0.34 | 0.04 |

(continued)

| Sample | Irradiation amount | Thickness of catalytic material (μm) | Etching rate (μm/min) |
|---|---|---|---|
| 24-2 | C | 0.55 | 0.07 |
| 24-3 | C | 0.93 | 0.17 |
| 24-4 | C | 1.43 | 0.18 |
| 24-5 | C | 2.02 | 0.28 |
| 25-1 | D | 0.54 | 0.03 |
| 25-2 | D | 0.81 | 0.06 |
| 25-3 | D | 1.28 | 0.08 |
| 25-4 | D | 2.02 | 0.09 |
| 26-1 | D | 0.27 | 0.02 |
| 26-2 | D | 0.45 | 0.03 |
| 26-3 | D | 0.63 | 0.04 |

Further, Fig. 23 shows a relationship between the thicknesses of the catalytic materials and the etching rates obtained from the evaluation results.

From Fig. 23, it has been confirmed that the etching rate increased and hence the depth of the obtained recess structure was increased by increasing the thickness of the catalytic material under the same DUV irradiation conditions. Further, it has been found that there was a tendency that the etching rate decreased as the DUV irradiation amount was increased as described above under the condition of the same thickness.

(Example 31)

Recessed structures were formed on the first surface of an object to be processed by a method similar to that in Example 3.

Firstly, a coating liquid containing a catalytic material was placed, i.e., applied, on the first surface of the substrate by a spin coating method. The above-described i-line resist was used as the catalytic material. Further, a pattern of the catalytic material was placed on the first surface of the substrate by exposure and a developing process. The pattern consisted of a plurality of lines each having a width of 7.5 μm.

After that, the substrate was irradiated with DUV by a method similar to that in Example 3. Note that the above-described low-pressure mercury lamp (Lamp A) was used for the DUV irradiation. The irradiation amount P was 36,000 $mJ/cm^2$.

After that, an etching process similar to that in Example 3 was performed. The etching processing temperature was 250°C, and the etching time was 500 seconds. As a result, recess structures corresponding to the lines of the pattern were formed.

The object to be processed obtained after the etching process is referred to as "Sample 31".

(Examples 32 to 36)

Recessed structures were formed on the first surface of an object to be processed by a method similar to that in Example 31.

However, in these examples, the widths of the catalytic materials placed on the surfaces and etching conditions were changed from one another.

The objects to be processed obtained after the etching processes are referred to as "Sample 31" to "Sample 36", respectively.

(Example 41)

As described hereinafter, recess structures were formed on one of the surfaces (first surface) of an object to be processed by an ICP-RIE method.

A quartz glass substrate similar to that used in Example 1 was used as the object to be processed.

A mask pattern was formed on the first surface of the substrate by a method described below.

Firstly, a Cr film having a thickness of about 1 μm was manufactured by a sputtering process. Next, a mask pattern consisting of a plurality of parallel lines each having a width of 10 μm was formed for the Cr film by combining photolithography using a photoresist and wet etching. After that, the photoresist was removed by acetone.
Next, an etching process was performed for the first surface of the substrate, on which the mask pattern had been formed, by an ICP-RIE method.
As a result, an area where the mask pattern was not placed on the first surface was etched, so that a plurality of grooves extending parallel to each other were formed.
The object to be processed obtained after the process is referred to as "Sample 41".

(Example 42)

As described below, a recess structure was formed on one of the surfaces (first surface) of the object to be processed by using a UV pulse laser.
A quartz glass substrate similar to that used in Example 1 was used as the object to be processed. The laser output power was 15 μJ; the frequency was 40 KHz; and the scanning speed was 100 mm/s. A groove was formed on the first surface by scanning the laser 200 times.
The object to be processed obtained after the machining is referred to as "Sample 42".

(Evaluation)

The surface roughness of the sidewall of the recess structure of each sample was measured. The surface roughness of the sidewall was measured by a 3D-AFM apparatus (NX-3DM: Parksystems).
Note that as the surface roughness, an average value ($Ra_{ave}$) of arithmetic average roughness Ra was measured as follows:

The lengthwise direction of the recess structure (the direction in which the recess structure extends as the surface of the sample is viewed from above) is defined as an X direction; the width direction (the direction parallel to the dimension of about 7.5 μm) is defined as a Y direction; and the depth direction is defined as a Z direction;
For each of samples of which the width of the recess structure was 7.5 μm or longer, the surface roughness is measured in an arbitrarily selected area of 5 μm extending in the X direction at a depth level of Z = z (i.e., at the bottom surface);
Next, the depth level is decreased by 19.5 nm (i.e., at a pitch of 19.5 nm), and the surface roughness is measured in the area of 5 μm extending in the X direction in a similar manner;
These steps are repeated, and lastly, the surface roughness is measured in the area of 5 μm extending in the X direction at a depth level of Z = 0 (i.e., on the surface side); and
An average value of arithmetic average roughness $Ra_{ave}$ was obtained by averaging, among the measurement results, values obtained in a range of Z = 0.2z to 0.8z.

Meanwhile, for each of samples of which the width of the recess structure was 2.5 μm, the surface roughness is measured in an arbitrarily selected area of 5 μm extending in the X direction at a depth level of Z = 5 μm;
Next, the depth level is decreased by 19.5 nm (i.e., at a pitch of 19.5 nm), and the surface roughness is measured in the area of 5 μm extending in the X direction in a similar manner;
These steps are repeated, and lastly, the surface roughness is measured in the area of 5 μm extending in the X direction at a depth level of Z = 0 (i.e., on the surface side); and
An average value of arithmetic average roughness $Ra_{ave}$ was obtained by averaging, among the measurement results, values obtained in a range of Z = 1 μm to 4 μm.
Further, in each sample, a cross section of the recess structure was observed by a scanning electron microscope (SEM), and various dimensions were measured. Further, the taper angle θ of the sidewall of the recess structure was measured by the method described above.
The manufacturing conditions and evaluation results of the samples are summarized in Table 4 shown below.

[Table 4]

| Sample | Processing method | Machining width (μm) | Etching conditions | | Surface roughness Ra of sidewall (nm) | Taper angle θ(° ) |
|---|---|---|---|---|---|---|
| | | | Temp. (° C) | Time (sec) | | |
| 31 | First method | 7.5 | 250 | 500 | 4.0 | 0.60 |

(continued)

| Sample | Processing method | Machining width (μm) | Etching conditions | | Surface roughness Ra of sidewall (nm) | Taper angle θ(° ) |
|---|---|---|---|---|---|---|
| | | | Temp. (° C) | Time (sec) | | |
| 32 | First method | 2.5 | 250 | 500 | 3.0 | 0.14 |
| 33 | First method | 7.5 | 250 | 1000 | 4.4 | 0.48 |
| 34 | First method | 2.5 | 250 | 1000 | 4.1 | 0.47 |
| 35 | First method | 2.5 | 350 | 1000 | 2.3 | 0.04 |
| 36 | First method | 2.5 | 350 | 2000 | 2.8 | 0.44 |
| 41 | RIE process | 9 | - | - | 11.8 | 6.09 |
| 42 | Laser machining | 10 | - | - | 65.6 | - |

As shown in Table 4, in each of Samples 31 to 36, the taper angle θ of the recess structure was 1° or smaller, so that it has been found that a "vertical recess structure" was formed in the sample.
Further, in each of Samples 31 to 36, the surface roughness Ra of the sidewall of the recess structure was in a range of 2.3 nm to 4.4 nm, so that it has been found that an extremely smooth side surface was formed in the sample.
Further, in each of Samples 31 to 36, it has been confirmed that "continuous streaks" were formed on the sidewall.
Fig. 24 shows a cross-section of the recess structure in Sample 34. From this photograph, it can be seen that a vertical recess structure was formed in Sample 34. Further, it has been confirmed that a vertical recess structure was also formed in each of Samples 31-33, 35, and 36.

(Embodiments of Present Invention)

The present invention includes embodiments described below.

(Embodiment 1)

A method for manufacturing a member with a recess structure, comprising:

(1) a step of placing a catalytic material on a part of a first surface of an object to be processed, the first surface being formed of an element of which a boiling point of a fluoride is 550°C or lower, and the catalytic material containing an organic compound containing a polar functional group;
(2) a step of irradiating the catalytic material with irradiation light containing deep ultraviolet light having a wavelength of 380 nm or shorter; and
(3) a step of exposing the object to be processed to a fluorine-containing gas at 80°C or higher, wherein

a recess structure is formed under the catalytic material on the first surface after the step (3).

(Embodiment 2)

The method described in Embodiment 1, wherein the polar functional group contains at least one group or bond selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

(Embodiment 3)

The method described in Embodiment 1 or 2, wherein the fluorine-containing gas is a hydrogen fluoride gas or a fluorine gas.

(Embodiment 4)

The method described in any one of Embodiments 1 to 3, wherein the step (3) is carried out in a range of 200°C to 450°C.

(Embodiment 5)

The method described in any one of Embodiments 1 to 4, wherein the first surface contains at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

(Embodiment 6)

The method described in any one of Embodiments 1 to 5, wherein the recess structure includes a bottomed structure and/or a penetrating structure.

(Embodiment 7)

The method described in Embodiment 6, wherein the recess structure is at least one of a bottomed hole, a penetrating hole, a bottomed groove, and a penetrating groove.

(Embodiment 8)

The method described in any one of Embodiments 1 to 7, wherein the object to be processed is formed of one member.

(Embodiment 9)

The method described in Embodiment 8, wherein the object to be processed contains $SiO_2$.

(Embodiment 10)

The method described in any one of Embodiments 1 to 7, wherein the object to be processed comprises one or more layers.

(Embodiment 11)

A method for manufacturing a member with a recess structure, comprising:

(1) a step of placing a catalytic material on each of a first area and a second area on a first surface of an object to be processed, the first surface being formed of an element of which a boiling point of a fluoride is 550°C or lower, the catalytic material containing an organic compound containing a polar functional group, and the catalytic material placed in the second area is thicker than the catalytic material placed in the first area;
(2) a step of irradiating the catalytic material with irradiation light containing deep ultraviolet light having a wavelength of 380 nm or shorter; and
(3) a step of exposing the object to be processed to a fluorine-containing gas at 80°C or higher, wherein

after the step (3), a first recess structure is formed under the catalytic material in the first area on the first surface, and a second recess structure is formed under the catalytic material in the second area thereon, and
the second recess structure is deeper than the first recess structure.

(Embodiment 12)

The method described in Embodiment 11, wherein the polar functional group contains at least one group or bond selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

(Embodiment 13)

The method described in Embodiment 11 or 12, wherein the fluorine-containing gas is a hydrogen fluoride gas or a fluorine gas.

(Embodiment 14)

The method described in any one of Embodiments 11 to 13, wherein the step (3) is carried out in a range of 200°C to 450°C.

(Embodiment 15)

The method described in any one of Embodiments 11 to 14, wherein the first surface contains at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

(Embodiment 16)

The method described in any one of Embodiments 11 to 15, wherein the second recess structure is at least one of a bottomed hole, a penetrating hole, a bottomed groove, and a penetrating groove.

(Embodiment 17)

The method described in any one of Embodiments 11 to 16, wherein the object to be processed is formed of one member.

(Embodiment 18)

The method described in Embodiment 17, wherein the object to be processed contains $SiO_2$.

(Embodiment 19)

The method described in any one of Embodiments 11 to 16, wherein the object to be processed comprises one or more layers.

(Embodiment 20)

A member with a recess structure on a first surface, wherein

the recess structure is a bottomed structure and/or a penetrating structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recess structure is defined by a first opening formed on the first surface, a peripheral sidewall, and a bottom surface or a second opening, and
the sidewall has surface roughness Ra of 5 nm or finer.

(Embodiment 21)

The member described in Embodiment 20, wherein the sidewall includes at least one streak extending from the first opening to the bottom surface or the second opening.

(Embodiment 22)

The member described in Embodiment 20 or 21, wherein the first surface further contains at least one element selected from the group consisting of H, N, Cl, Br, and O.

(Embodiment 23)

The member described in any one of Embodiments 20 to 22, wherein
when a minimum dimension of the first opening is represented by a; a minimum dimension of the bottom surface of the recess structure is represented by b; a depth of the recess structure is represented by c; and an angle $\theta$ expressed by a below-shown Expression (3) is referred to as a taper angle,
[Expression 2]

$$\text{Taper Angle } \theta\,(^\circ) = \cos^{-1}\left(\frac{c}{\sqrt{\left(\frac{a-b}{2}\right)^2 + c^2}}\right) \qquad (3)$$

the taper angle $\theta$ is 0° or higher and 2° or lower ($0° \leq \theta \leq 2°$).

This application is based upon and claims the benefit of priorities from Japanese Patent Application No. 2022-176336, filed on November 2, 2022, and Japanese Patent Application No. 2023-089928, filed on May 31, 2023, the disclosures of which are incorporated herein in their entirety by reference.

Reference Signs List

| | |
|---|---|
| 1 | OBJECT TO BE PROCESSED |
| 3 | CATALYTIC MATERIAL |
| 5 | RECESS STRUCTURE |
| 6 | BOTTOM SURFACE |
| 7 | SIDEWALL |
| 7a | FIRST SIDEWALL PART |
| 8a | COVERED AREA |
| 8b | UNCOVERED AREA |
| 50 | RECESS |
| 52 | OPENING |
| 56 | BOTTOM SURFACE |
| 57 | SIDEWALL |
| 100 | MEMBER |
| 110 | OBJECT TO BE PROCESSED |
| 112 | FIRST SURFACE |
| 114 | SECOND SURFACE |
| 130 | CATALYTIC MATERIAL |
| 131 | PATTERN |
| 140a | COVERED AREA |
| 140b | UNCOVERED AREA |
| 150 | RECESS STRUCTURE |
| 300 | FIRST MEMBER |
| 302 | FIRST SURFACE |
| 304 | SECOND SURFACE |
| 350 | RECESS STRUCTURE |
| 352 | OPENING |
| 356 | BOTTOM SURFACE |
| 357 | SIDEWALL |
| 380 | CONTINUOUS STREAK |
| 410 | OBJECT TO BE PROCESSED |
| 412 | FIRST SURFACE |
| 414 | SECOND SURFACE |
| 419-1 | FIRST AREA |
| 419-2 | SECOND AREA |
| 419-3 | THIRD AREA |
| 430 (430-1 to 430-3) | CATALYTIC MATERIAL |
| 450 (450-1 to 450-3) | RECESS STRUCTURE |
| (a) | HF MOLECULE |
| (b) | Si ATOM |
| (c) | OH GROUP |
| (d) | Si-F BOND |
| (e) | $-\delta$ PART |
| (f) | $+\delta$ PART |
| (g) | $H_2O$ MOLECULE |
| L | EXTENSION AXIS |

**Claims**

1. A method for manufacturing a member with a recess structure, comprising:

(1) a step of placing a catalytic material on a part of a first surface of an object to be processed, the first surface being formed of an element of which a boiling point of a fluoride is 550°C or lower, and the catalytic material containing an organic compound containing a polar functional group;
(2) a step of irradiating the catalytic material with irradiation light containing deep ultraviolet light having a wavelength of 380 nm or shorter; and
(3) a step of exposing the object to be processed to a fluorine-containing gas at 80°C or higher, wherein

a recess structure is formed under the catalytic material on the first surface after the step (3).

2. The method according to claim 1, wherein the polar functional group contains at least one group or bond selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

3. The method according to claim 1 or 2, wherein the fluorine-containing gas is a hydrogen fluoride gas or a fluorine gas.

4. The method according to claim 1 or 2, wherein the step (3) is carried out in a range of 200°C to 450°C.

5. The method according to claim 1 or 2, wherein the first surface contains at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

6. The method according to claim 1 or 2, wherein the recess structure includes a bottomed structure and/or a penetrating structure.

7. The method according to claim 6, wherein the recess structure is at least one of a bottomed hole, a penetrating hole, a bottomed groove, and a penetrating groove.

8. The method according to claim 1 or 2, wherein the object to be processed is formed of one member.

9. The method according to claim 8, wherein the object to be processed contains $SiO_2$.

10. The method according to claim 1 or 2, wherein the object to be processed comprises one or more layers.

11. A method for manufacturing a member with a recess structure, comprising:

(1) a step of placing a catalytic material on each of a first area and a second area on a first surface of an object to be processed, the first surface being formed of an element of which a boiling point of a fluoride is 550°C or lower, the catalytic material containing an organic compound containing a polar functional group, and the catalytic material placed in the second area is thicker than the catalytic material placed in the first area;
(2) a step of irradiating the catalytic material with irradiation light containing deep ultraviolet light having a wavelength of 380 nm or shorter; and
(3) a step of exposing the object to be processed to a fluorine-containing gas at 80°C or higher, wherein
after the step (3), a first recess structure is formed under the catalytic material in the first area on the first surface, and a second recess structure is formed under the catalytic material in the second area thereon, and
the second recess structure is deeper than the first recess structure.

12. The method according to claim 11, wherein the polar functional group contains at least one group or bond selected from the group consisting of a hydroxy group, an aldehyde group, a carboxy group, an amino group, a sulfo group, a thiol group, an amide bond, a carbonyl group, a nitro group, a cyano group, an ether bond, and an ester bond.

13. The method according to claim 11 or 12, wherein the fluorine-containing gas is a hydrogen fluoride gas or a fluorine gas.

14. The method according to claim 11 or 12, wherein the step (3) is carried out in a range of 200°C to 450°C.

**15.** The method according to claim 11 or 12, wherein the first surface contains at least one element selected from the group consisting of H, B, C, N, O, Si, P, S, Cl, Ti, V, Cr, Ge, As, Se, Br, Nb, Mo, Tc, Ru, Rh, Sn, Sb, Te, I, Ta, W, Re, Os, Ir, Pt, and Au.

**16.** The method according to claim 11 or 12, wherein the second recess structure is at least one of a bottomed hole, a penetrating hole, a bottomed groove, and a penetrating groove.

**17.** The method according to claim 11 or 12, wherein the object to be processed is formed of one member.

**18.** The method according to claim 17, wherein the object to be processed contains $SiO_2$.

**19.** The method according to claim 11 or 12, wherein the object to be processed comprises one or more layers.

**20.** A member with a recess structure on a first surface, wherein

the recess structure is a bottomed structure and/or a penetrating structure,
the first surface contains at least one element selected from the group consisting of B, C, Si, P, S, Ti, V, Cr, Ge, As, Se, Nb, Mo, Tc, Ru, Rh, Sn, Sb, Te, I, Ta, W, Re, Os, Ir, Pt, and Au,
the recess structure is defined by a first opening formed on the first surface, a peripheral sidewall, and a bottom surface or a second opening, and
the sidewall has surface roughness Ra (arithmetic average roughness Ra) of 5 nm or finer.

**21.** The member according to claim 20, wherein the sidewall includes at least one streak extending from the first opening to the bottom surface or the second opening.

**22.** The member according to claim 20 or 21, wherein the first surface further contains at least one element selected from the group consisting of H, N, Cl, Br, and O.

**23.** The member according to claim 20 or 21, wherein

when a minimum dimension of the first opening is represented by a; a minimum dimension of the bottom surface of the recess structure is represented by b; a depth of the recess structure is represented by c; and an angle $\theta$ expressed by a below-shown Expression (1) is referred to as a taper angle,
[Expression 1]

$$\text{Taper Angle } \theta\,(^\circ) = \cos^{-1}\left(\frac{c}{\sqrt{\left(\frac{a-b}{2}\right)^2 + c^2}}\right) \qquad \text{Expression (1)}$$

the taper angle $\theta$ is 0° or higher and 2° or lower ($0^\circ \le \theta \le 2^\circ$).

Fig. 1

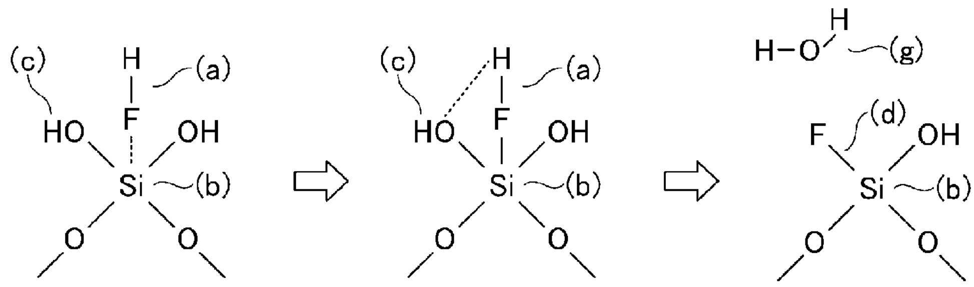

(i) (ii) (iii)

Fig. 2

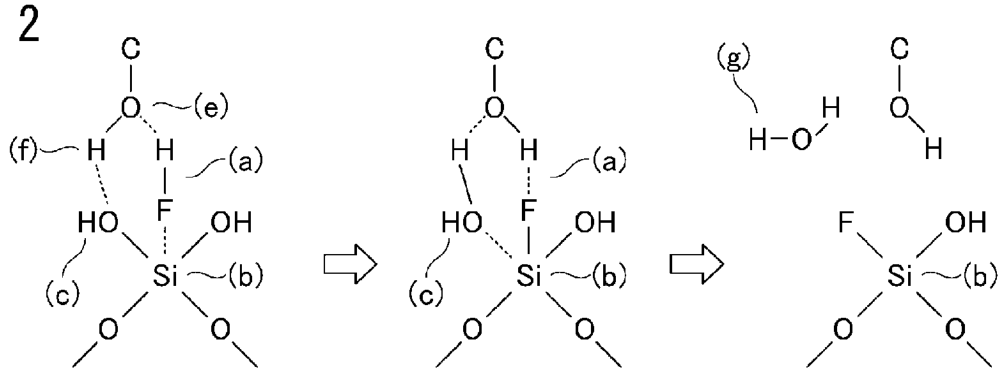

(i) (ii) (iii)

Fig. 3

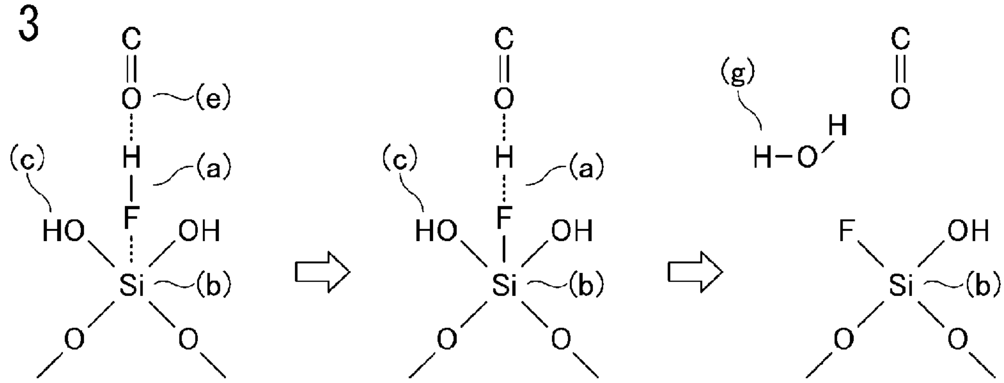

(i) (ii) (iii)

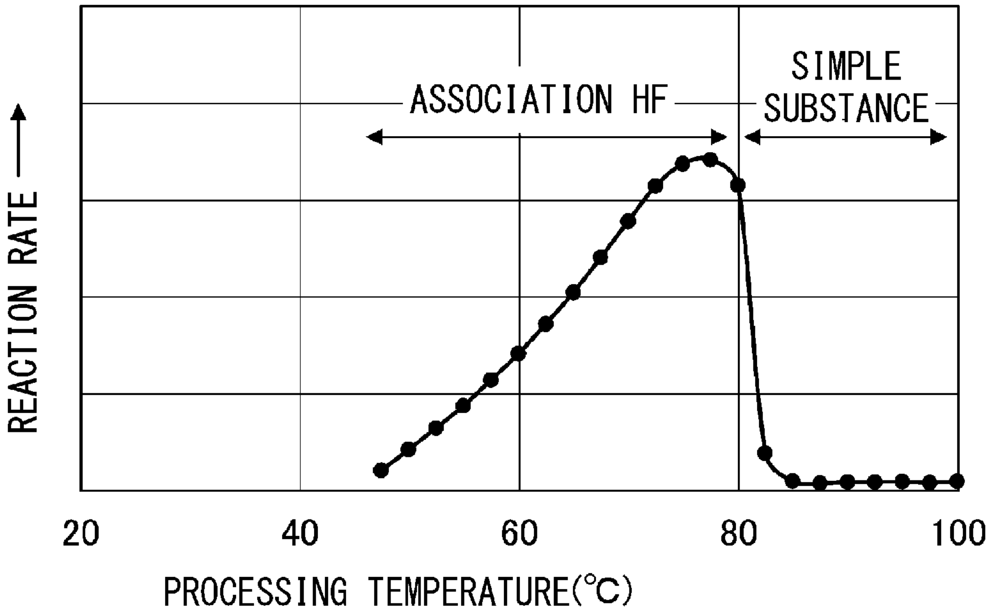
REACTION RATE
ASSOCIATION HF
SIMPLE SUBSTANCE
20
40
60
80
100
PROCESSING TEMPERATURE(°C)

Fig. 4

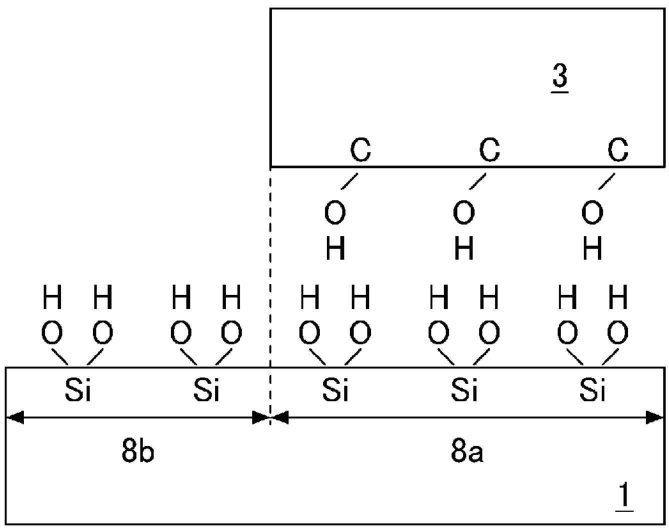
3
C C C
O O O
H H H
H H H H H H H H H H
O O O O O O O O O O
Si Si Si Si Si
8b
8a
1

Fig. 5

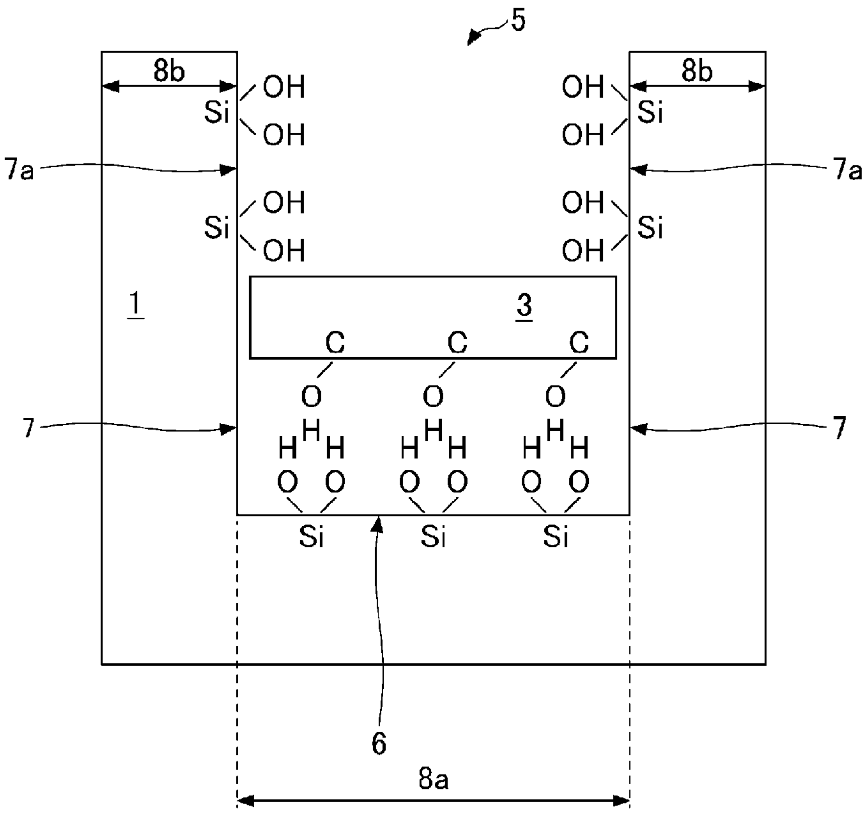
5
8b
8b
OH
Si
OH
OH
Si
OH
7a
7a
OH
Si
OH
OH
Si
OH
1
3
C
C
C
O
O
O
7
7
H
H H
H
H H
H
H H
O O
O O
O O
Si
Si
Si
6
8a

Fig. 6

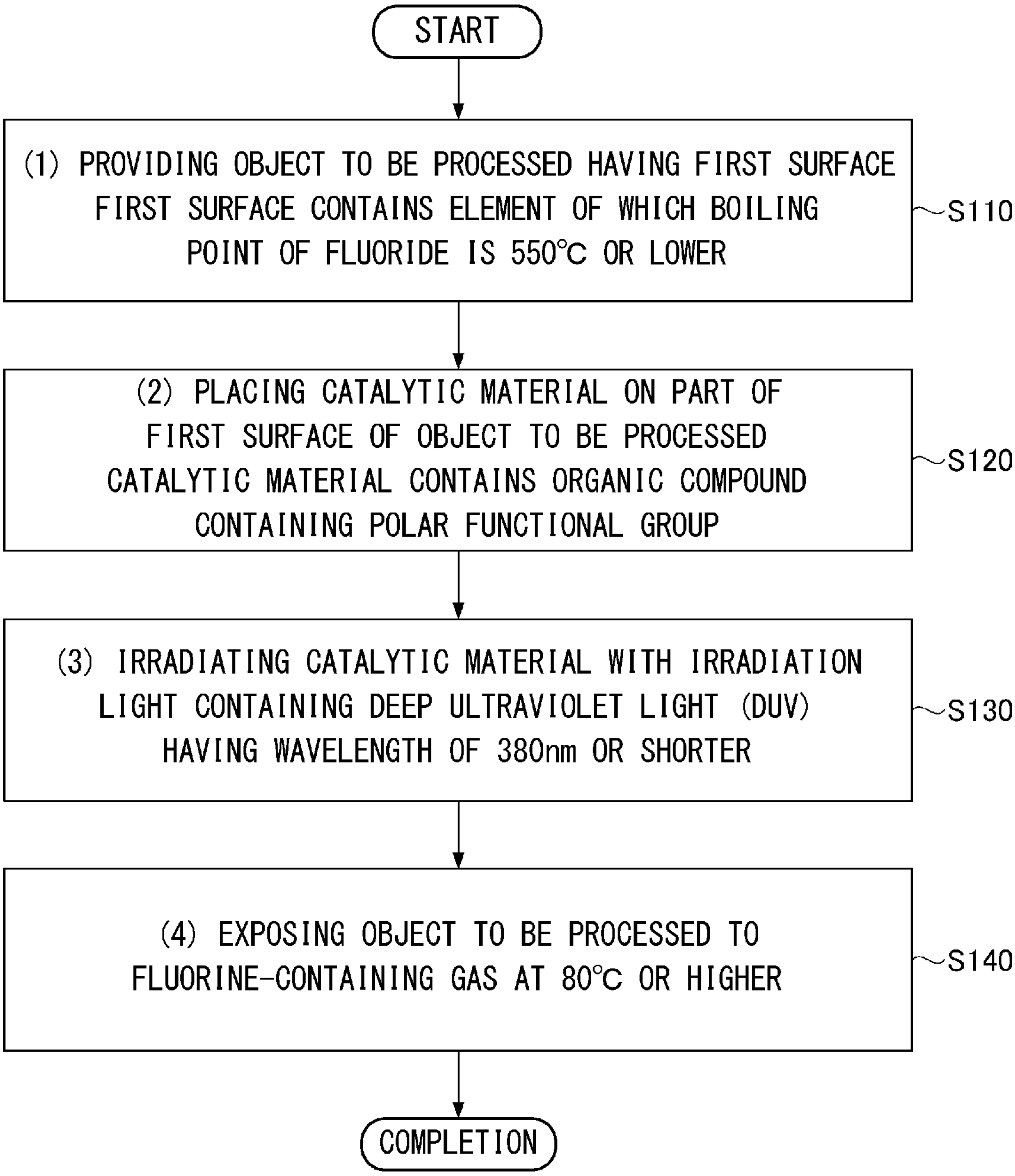
START
(1) PROVIDING OBJECT TO BE PROCESSED HAVING FIRST SURFACE
FIRST SURFACE CONTAINS ELEMENT OF WHICH BOILING POINT OF FLUORIDE IS 550°C OR LOWER
S110
(2) PLACING CATALYTIC MATERIAL ON PART OF FIRST SURFACE OF OBJECT TO BE PROCESSED
CATALYTIC MATERIAL CONTAINS ORGANIC COMPOUND CONTAINING POLAR FUNCTIONAL GROUP
S120
(3) IRRADIATING CATALYTIC MATERIAL WITH IRRADIATION LIGHT CONTAINING DEEP ULTRAVIOLET LIGHT (DUV) HAVING WAVELENGTH OF 380nm OR SHORTER
S130
(4) EXPOSING OBJECT TO BE PROCESSED TO FLUORINE-CONTAINING GAS AT 80°C OR HIGHER
S140
COMPLETION

Fig. 7

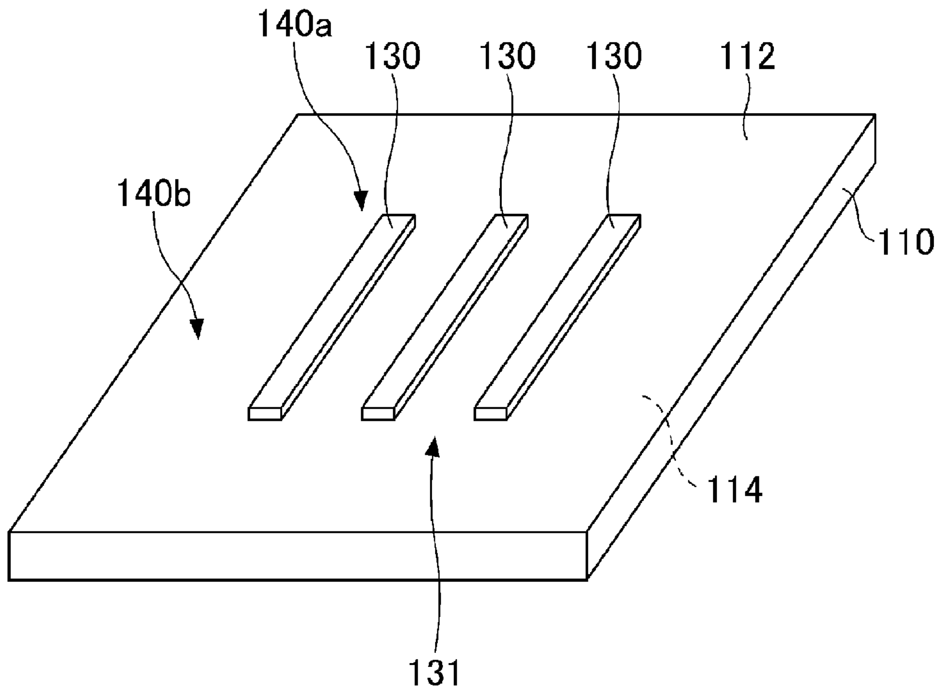
140a
130
130
130
112
140b
110
114
131

Fig. 8

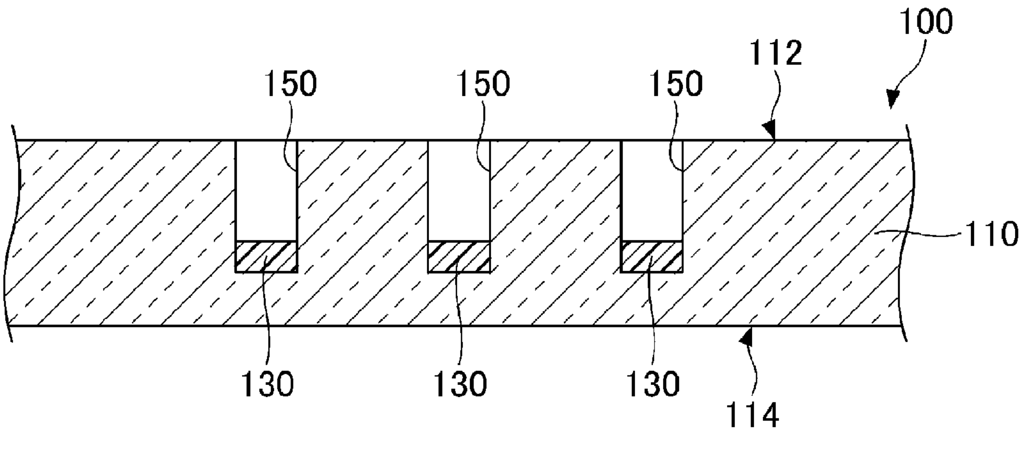
100
112
150
150
150
110
130
130
130
114

Fig. 9

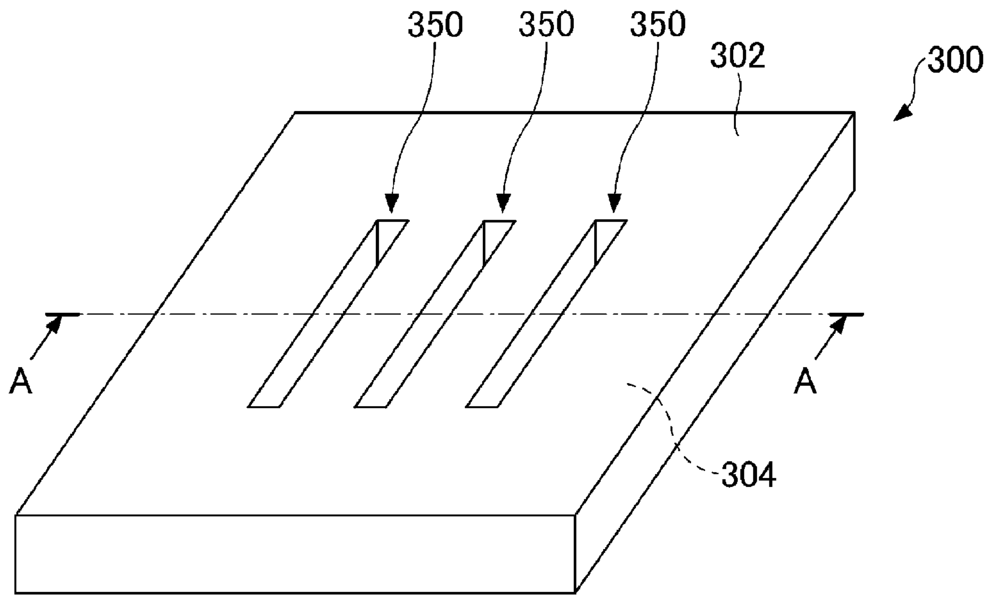
350
350
350
302
300
A
A
304

Fig. 10

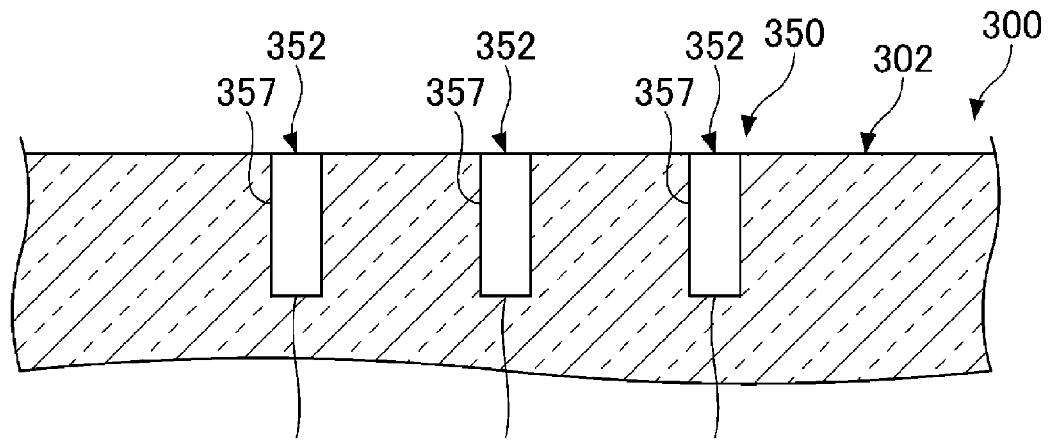
352
357
352
357
352
357
350
302
300
356
356
356

Fig. 11

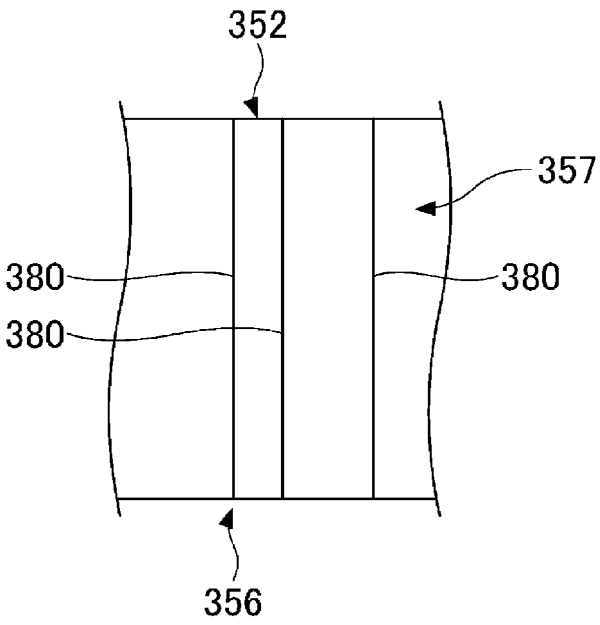


Fig. 12

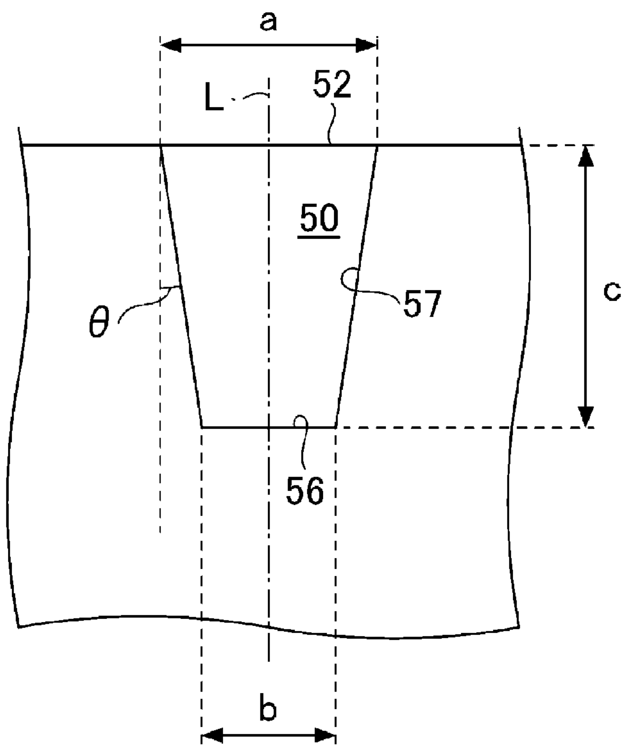


Fig. 13

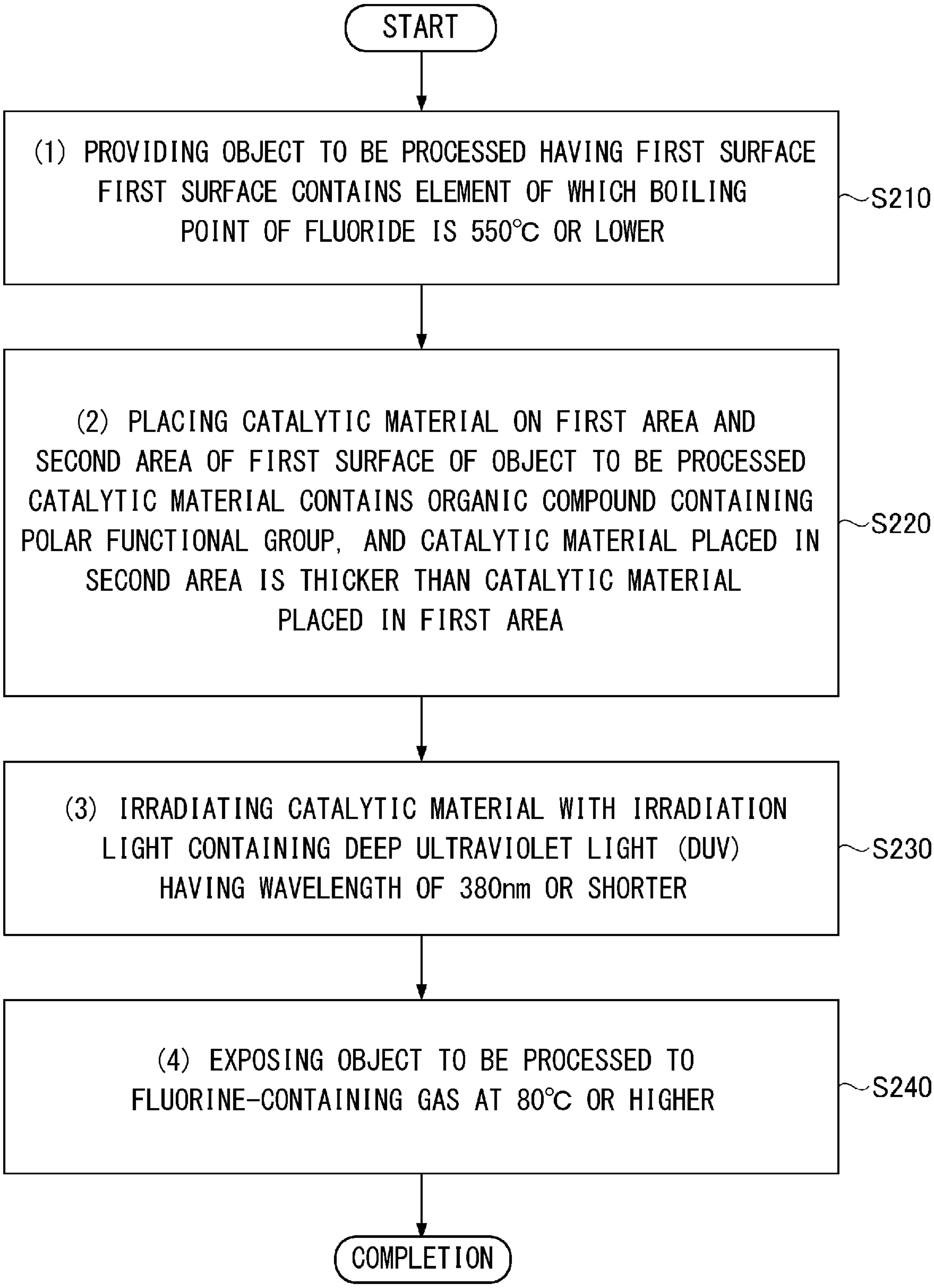
START
(1) PROVIDING OBJECT TO BE PROCESSED HAVING FIRST SURFACE
FIRST SURFACE CONTAINS ELEMENT OF WHICH BOILING
POINT OF FLUORIDE IS 550°C OR LOWER
S210
(2) PLACING CATALYTIC MATERIAL ON FIRST AREA AND
SECOND AREA OF FIRST SURFACE OF OBJECT TO BE PROCESSED
CATALYTIC MATERIAL CONTAINS ORGANIC COMPOUND CONTAINING
POLAR FUNCTIONAL GROUP, AND CATALYTIC MATERIAL PLACED IN
SECOND AREA IS THICKER THAN CATALYTIC MATERIAL
PLACED IN FIRST AREA
S220
(3) IRRADIATING CATALYTIC MATERIAL WITH IRRADIATION
LIGHT CONTAINING DEEP ULTRAVIOLET LIGHT (DUV)
HAVING WAVELENGTH OF 380nm OR SHORTER
S230
(4) EXPOSING OBJECT TO BE PROCESSED TO
FLUORINE-CONTAINING GAS AT 80°C OR HIGHER
S240
COMPLETION

Fig. 14

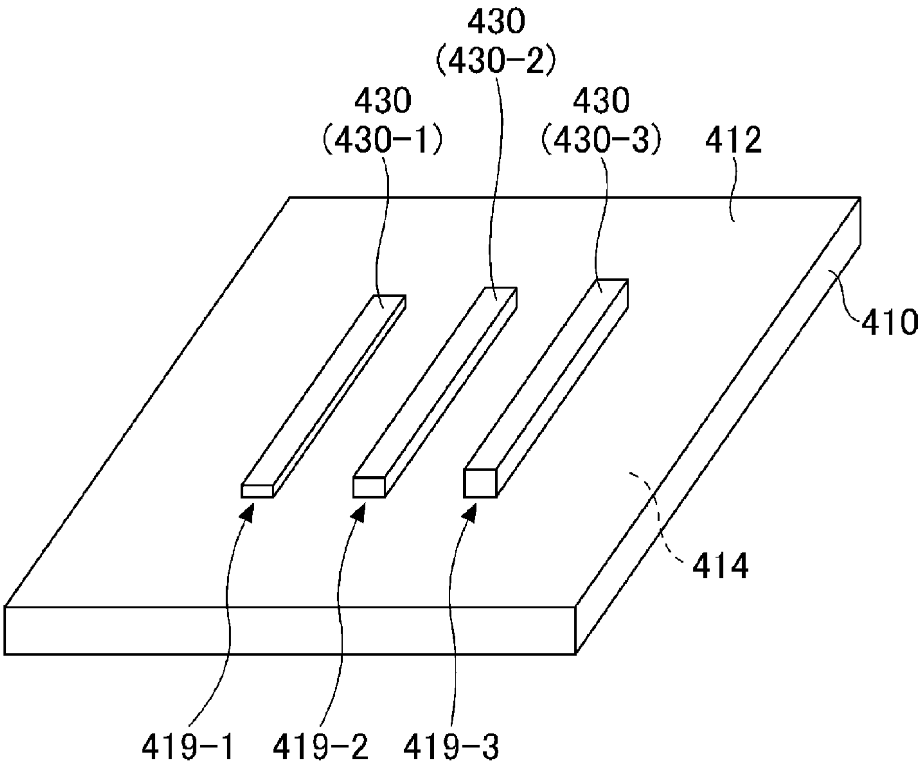
430
(430-2)
430
(430-1)
430
(430-3)
412
410
414
419-1
419-2
419-3

Fig. 15

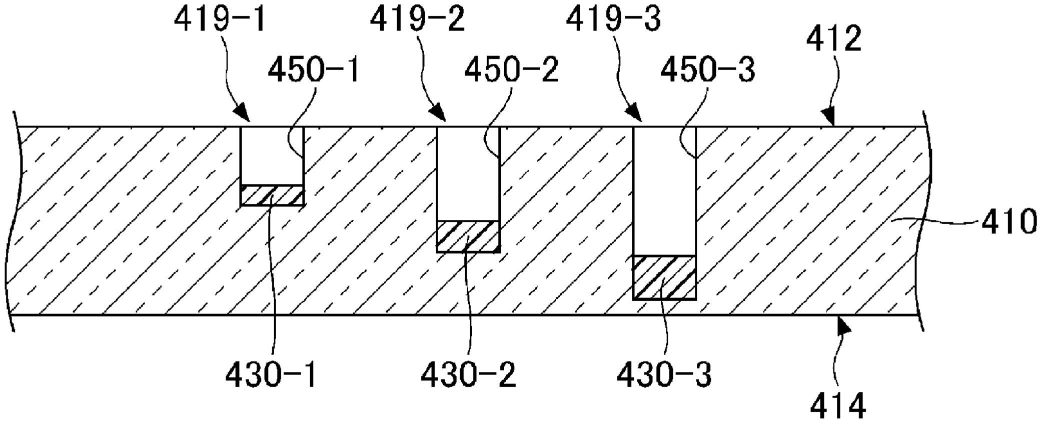
419-1
419-2
419-3
412
450-1
450-2
450-3
410
430-1
430-2
430-3
414

Fig. 16

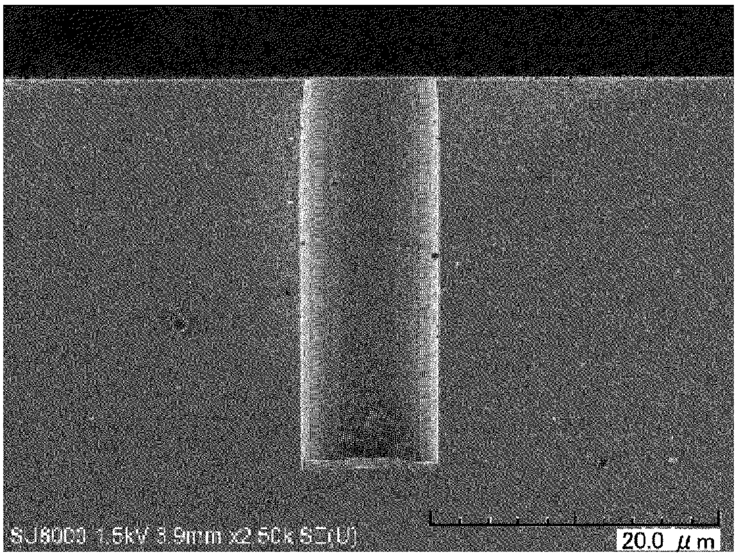
SU8000 1.5kV 3.9mm x2.50k SE(U)
20.0 μm

Fig. 17

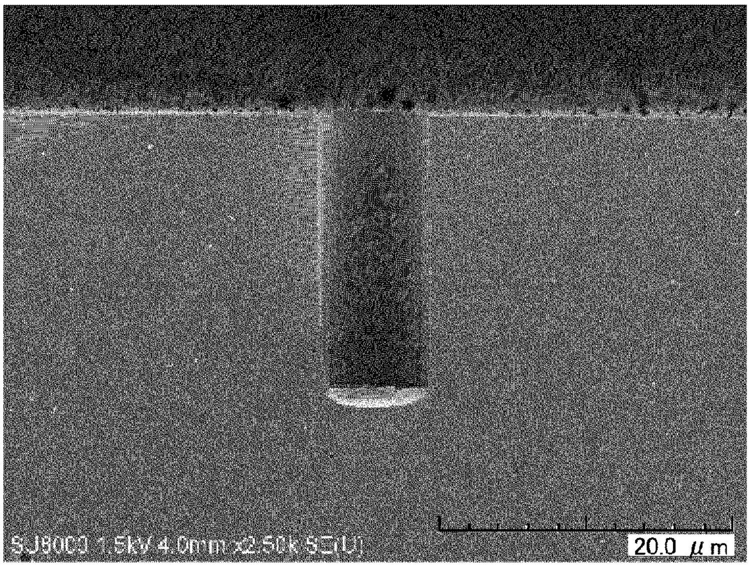
SU8000 1.5kV 4.0mm x2.50k SE(U)
20.0 μm

Fig. 18

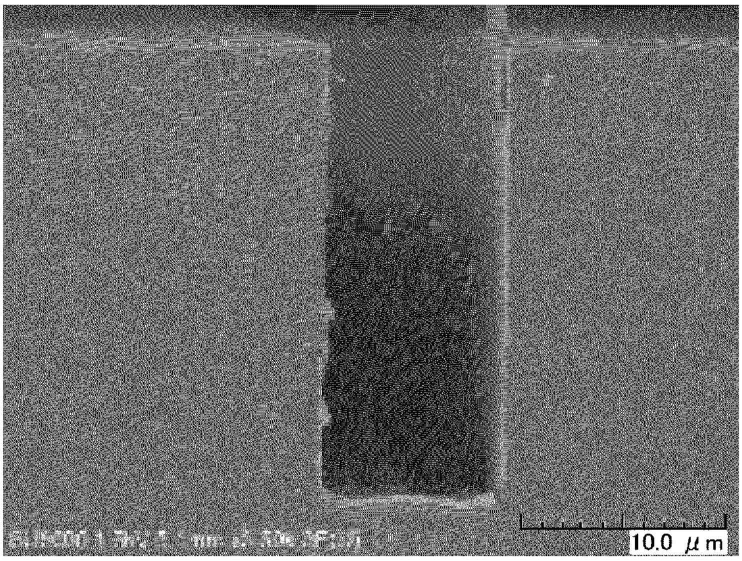


Fig. 19

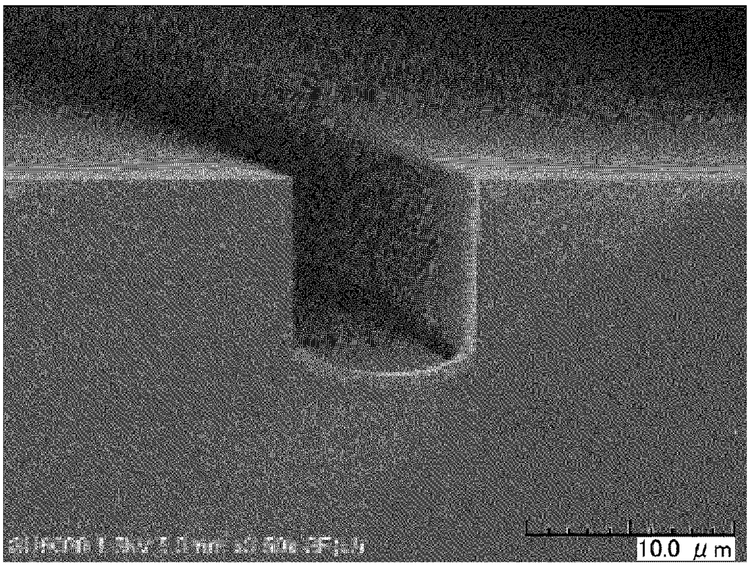


Fig. 20

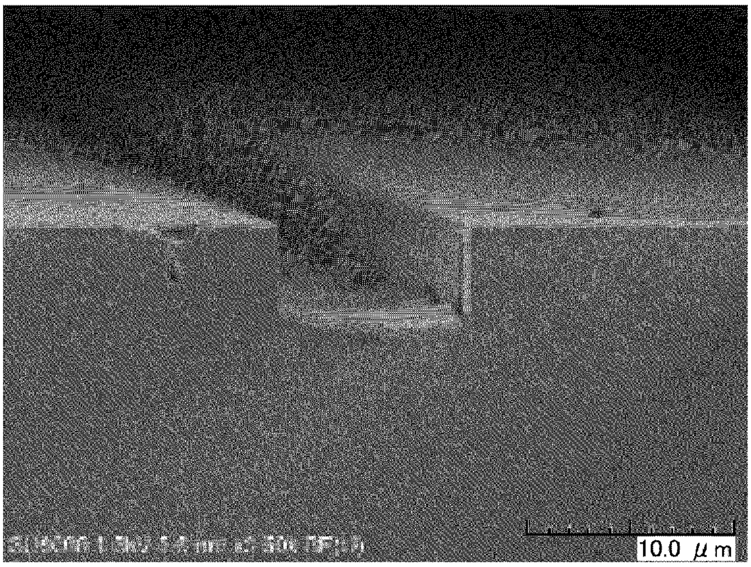
10.0 μm

Fig. 21

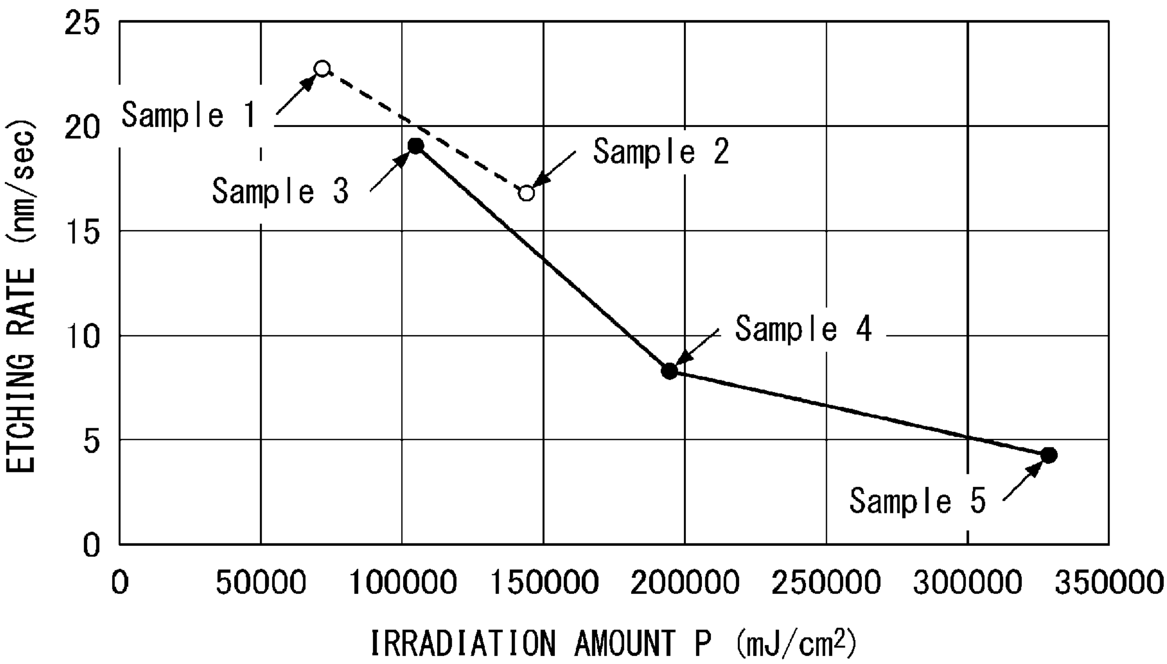
25
20
15
10
5
0
ETCHING RATE (nm/sec)
Sample 1
Sample 2
Sample 3
Sample 4
Sample 5
0
50000
100000
150000
200000
250000
300000
350000
IRRADIATION AMOUNT P (mJ/cm2)

Fig. 22

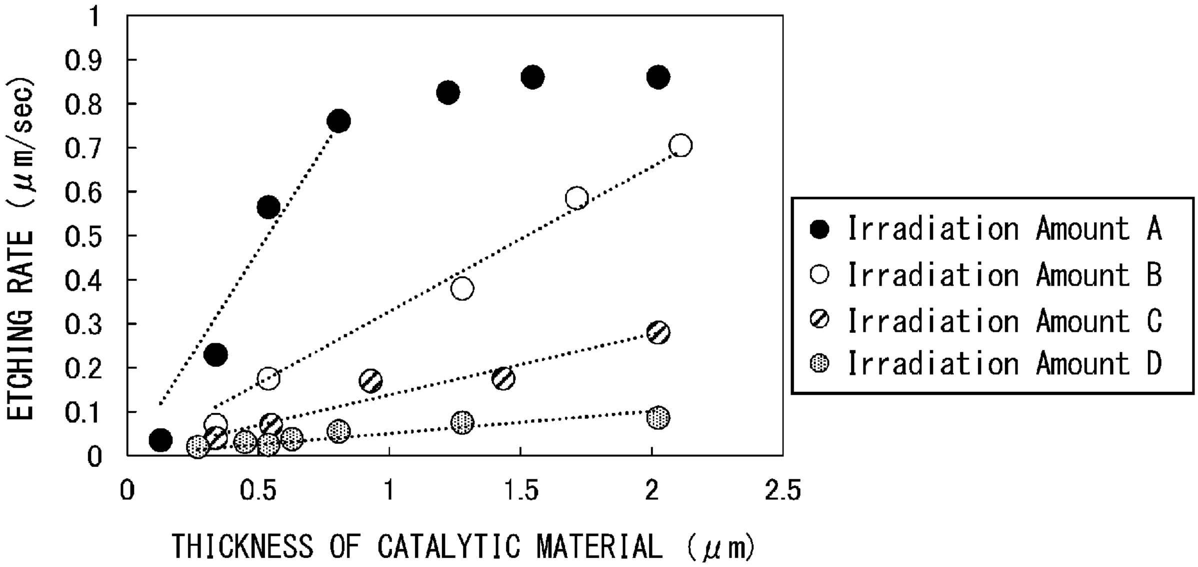
ETCHING RATE (μm/sec)
1
0.9
0.8
0.7
0.6
0.5
0.4
0.3
0.2
0.1
0
0
0.5
1
1.5
2
2.5
THICKNESS OF CATALYTIC MATERIAL (μm)
Irradiation Amount A
Irradiation Amount B
Irradiation Amount C
Irradiation Amount D

Fig. 23

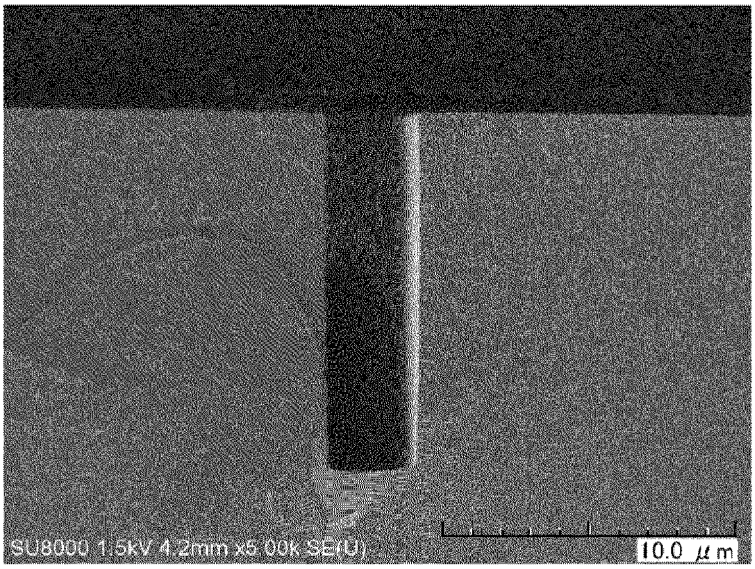
SU8000 1.5kV 4.2mm x5.00k SE(U)
10.0 μm

Fig. 24

**INTERNATIONAL SEARCH REPORT**

International application No.
**PCT/JP2023/037673**

**A. CLASSIFICATION OF SUBJECT MATTER**

***H01L 21/302***(2006.01)i; ***C23F 1/12***(2006.01)i; ***H01L 21/3065***(2006.01)i
FI: H01L21/302 201A; C23F1/12; H01L21/302 105A

According to International Patent Classification (IPC) or to both national classification and IPC

**B. FIELDS SEARCHED**

Minimum documentation searched (classification system followed by classification symbols)

H01L21/302; C23F1/12; H01L21/3065

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 55-87436 A (FUJITSU LTD) 02 July 1980 (1980-07-02)<br>column 1, line 12 to column 2, line 12, column 3, line 4 to column 5, line 19, fig. 1-2 | 1, 3-10 |
| A | entire text, all drawings | 2, 11-19 |
| Y | JP 53-1198 A (INTAANASHONARU PURAZUMA CORP) 07 January 1978 (1978-01-07)<br>column 2, line 14 to column 4, line 8, column 5, line 6 to column 11, line 3, column 11, line 15 to column 13, line 9, fig. 1, 4-5 | 1, 3-10 |
| A | entire text, all drawings | 2, 11-19 |
| X | JP 2018-82114 A (RENESAS ELECTRONICS CORP) 24 May 2018 (2018-05-24)<br>paragraphs [0026]-[0027], [0034], fig. 3 | 20, 22 |
| Y | paragraphs [0026]-[0027], [0034], fig. 3 | 21, 23 |
| A | entire text, all drawings | 2, 11-19 |
| X | JP 2017-117963 A (TOYOTA MOTOR CORP) 29 June 2017 (2017-06-29)<br>paragraphs [0020]-[0021], fig. 6-7 | 20, 22 |
| A | entire text, all drawings | 2, 11-19 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 December 2023** | **09 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No.
PCT/JP2023/037673

C. DOCUMENTS CONSIDERED TO BE RELEVANT

| Category* | Citation of document, with indication, where appropriate, of the relevant passages | Relevant to claim No. |
|---|---|---|
| X | JP 2012-104858 A (JAPAN AVIATION ELECTRONICS INDUSTRY LTD) 31 May 2012 (2012-05-31)<br>paragraphs [0096]-[0098], fig. 9 | 20 |
| A | entire text, all drawings | 2, 11-19 |
| Y | JP 2021-190679 A (TAIWAN CARBON NANO TECHNOLOGY CORPORATION) 13 December 2021 (2021-12-13)<br>paragraphs [0049]-[0050], fig. 2D | 21, 23 |
| A | entire text, all drawings | 2, 11-19 |

Form PCT/ISA/210 (second sheet) (January 2015)

**INTERNATIONAL SEARCH REPORT**
**Information on patent family members**

International application No.
**PCT/JP2023/037673**

| Patent document cited in search report | Publication date (day/month/year) | Patent family member(s) | Publication date (day/month/year) |
|---|---|---|---|
| JP 55-87436 A | 02 July 1980 | (Family: none) | |
| JP 53-1198 A | 07 January 1978 | US 4127437 A<br>column 1, line 45 to column 2, line 2, column 2, lines 28-37, column 2, line 55 to column 4, line 53, column 4, line 65 to column 5, line 60, fig. 1, 4-5 | |
| JP 2018-82114 A | 24 May 2018 | US 2018/0145137 A1<br>paragraphs [0040]-[0041], [0048], fig. 3<br>CN 108074818 A | |
| JP 2017-117963 A | 29 June 2017 | (Family: none) | |
| JP 2012-104858 A | 31 May 2012 | US 2009/0305507 A1<br>paragraphs [0107]-[0109], fig. 9<br>EP 2079103 A1<br>KR 10-2009-0074217 A<br>CN 101563759 B | |
| JP 2021-190679 A | 13 December 2021 | US 10991595 B1<br>column 6, lines 14-39, fig. 2D<br>CN 113764268 A | |

Form PCT/ISA/210 (patent family annex) (January 2015)

## REFERENCES CITED IN THE DESCRIPTION

*This list of references cited by the applicant is for the reader’s convenience only. It does not form part of the European patent document. Even though great care has been taken in compiling the references, errors or omissions cannot be excluded and the EPO disclaims all liability in this regard.*

### Patent documents cited in the description


- JP 2022176336 A
- JP 2023089928 A


### Non-patent literature cited in the description


- **XIAO LI** ; **KING YUK CHAN** ; **RODICA RAMER**. Fabrication of Through via Holes in Ultra-Thin Fused SilicaWafers for Microwave and Millimeter-Wave Applications. *micromachines*, 2018, vol. 9, 138